# EUROPEAN PATENT APPLICATION

(11) **EP 4 425 560 A1**
(43) Date of publication of application: **04.09.2024**
(21) Application number: 24159629.5
(22) Date of filing: 26.02.2024
(51) Int. Cl.: H01L 27/146, H04N 25/131, H04N 25/42, H04N 25/79, H04N 25/11, H04N 25/133, H04N 25/78, G06F 3/01, G06T 19/00, G02B 27/01

(54) **PIXEL SENSOR USING A DUAL PIXEL ARRAY**

(30) Priority: 02.03.2023 US 202318177646
(71) Applicant: Meta Platforms Technologies, LLC, Menlo Park, CA 94025 (US)
(72) Inventor: Liao, Guangxun, Menlo Park (US); Liang, Minhua, Menlo Park (US); Bardagjy, Andrew Matthew, Menlo Park (US)
(74) Representative: Murgitroyd & Company

(57) **Abstract**

The present invention relates in one example to apparatus for providing a dual pixel array includes an array of pixels, each pixel comprising a plurality of photodiodes, each photodiode configured to generate a charge in response to incoming light and connected to at least one charge storage device. The plurality of photodiodes comprises one or more color photodiodes each including a chromatic filter, a color-select switch, and having at least one associated monochrome photodiode with a monochrome filter and a monochrome-select switch. The dual pixel array further comprises one or more analog-to-digital converters ("ADC"), each ADC connected to at least one of the charge storage devices of the photodiodes via the respective select switch, configured to selectively convert one or more stored voltages into a pixel value in response to a control signal. The color photodiodes and the monochrome photodiodes are arranged according to an arrangement.

## Description

### BACKGROUND

A typical image sensor includes an array of pixel cells. Each pixel cell may include a photodiode to sense light by converting photons into charge (e.g., electrons or holes). The charge generated by the array of photodiodes can then be quantized by an analog-to-digital converter (ADC) into digital values to generate a digital image. The digital image may be exported from the sensor to another system (e.g., a viewing system for viewing the digital image, a processing system for interpreting the digital image, a compilation system for compiling a set of digital images, etc.).

### SUMMARY

Various examples are described for a pixel sensor using a dual pixel array.

According to a first aspect of the present invention, there is provided sensor apparatus comprising a dual pixel array comprising a controller, a memory, and an array of pixels, each pixel comprising a plurality of photodiodes, each photodiode configured to generate a charge in response to incoming light, wherein the plurality of photodiodes comprises one or more color photodiodes each including a chromatic filter; a color-select switch; and having at least one associated monochrome photodiode with a monochrome filter and a monochrome-select switch; and a plurality of charge storage devices, each charge storage device configured to convert the charge to a voltage, wherein the color photodiodes and the monochrome photodiodes are arranged according to an arrangement; one or more color analog-to-digital converters ("ADC"), each color ADC connected to at least one of the charge storage devices of the color photodiodes via the respective color-select switch, configured to selectively convert one or more stored voltages into a pixel value in response to a control signal; and one or more monochrome ADCs, each monochrome ADC connected to at least one of the charge storage devices of the monochrome photodiodes via the respective monochrome-select switch, configured to selectively convert one or more stored voltages into a pixel value in response to a control signal.

Optionally, the color photodiodes include a red photodiode, a green photodiode, and a blue photodiode, the color of the photodiode determined by the color of its associated chromatic filter. Optionally, the monochrome photodiodes include an infra-red filter, an ultraviolet filter, or a monochrome filter.

Optionally, the sensor apparatus is configured such that each photodiode has an associated microlens. Optionally, adjacent photodiodes are associated with a 1x2 microlens. Optionally, a microlens is associated with four photodiodes in 2x2 configuration. Optionally, a microlens is associated with eight photodiodes in a 4x2 configuration.

Optionally, the arrangement comprises a first row including a repeating pattern of color and monochrome photodiodes and a second row including a repeating pattern of color and monochrome photodiodes, wherein successive rows of the arrangement alternate between the first and second rows. Optionally, the repeating pattern of the first row includes photodiodes with filters having the sequence: red, monochrome, green, monochrome and the repeating pattern of the second row includes photodiodes with filters having the sequence: green, monochrome, blue, monochrome.

Optionally, the arrangement comprises a third row including a repeating pattern of color and monochrome photodiodes and a fourth row including a repeating pattern of monochrome and color photodiodes, wherein successive rows of the arrangement alternate between the third and fourth rows. Optionally, the repeating pattern of the third row includes photodiodes with filters having the sequence: red, monochrome, green, monochrome and the repeating pattern of the fourth row includes photodiodes with filters having the sequence: monochrome, green, monochrome, blue.

Optionally, the arrangement includes at least one color photodiode adjacent to at least one monochrome photodiode.

Optionally, the adjacent photodiodes are associated with a first microlens.

Optionally, a second microlens is associated with four photodiodes arranged in a 2x2 configuration.

Optionally, a third microlens is associated with eight photodiodes arranged in a 4x2 configuration

Optionally, the sensor apparatus includes color ADCs such that comprise at least one red ADC associated with the red photodiode, at least one green ADC associated with the green photodiode, and at least one blue ADC associated with the blue photodiode. Optionally, the pixel values associated with the red, green, and blue ADCs are multiplied by 0.271, 0.589, and 0.0073, respectively, and combined with the pixel value from the monochrome ADCs of the associated monochrome photodiodes to produce an enhanced monochrome image. Optionally, a conversion factor for each color is determined according to the environmental lighting conditions and the pixel value from a first monochrome ADCs is divided by a red conversion factor and combined with the pixel value from the associated red ADC, the pixel value from a second monochrome ADC is divided by a green conversion factor and combined with the pixel value from the associated green ADC, and the pixel value from a third monochrome ADC is divided by a blue conversion factor and combined with the pixel value from the associated blue ADC to produce an enhanced color image.

According to a further aspect of the present invention, there is provided a system comprising a head-mounted display, wherein the head-mounted display comprises a dual pixel array comprising a controller, a memory, and an array of pixels, each pixel comprising a plurality of photodiodes, each photodiode configured to generate a charge in response to incoming light, wherein the plurality of photodiodes comprises one or more color photodiodes each including a chromatic filter; a color-select switch; and having at least one associated monochrome photodiode with a monochrome filter and a monochrome-select switch; and a plurality of charge storage devices, each charge storage device configured to convert the charge to a voltage, wherein the color photodiodes and the monochrome photodiodes are arranged according to an arrangement; one or more color analog-to-digital converters ("ADC"), each color ADC connected to at least one of the charge storage devices of the color photodiodes via the respective color-select switch, configured to selectively convert one or more stored voltages into a pixel value in response to a control signal; and one or more monochrome ADCs, each monochrome ADC connected to at least one of the charge storage devices of the monochrome photodiodes via the respective monochrome-select switch, configured to selectively convert one or more stored voltages into a pixel value in response to a control signal.

Optionally, the system further comprises a color filter array ("CFA"), wherein the CFA comprises one or more chromatic filters of the color photodiodes and each chromatic filter of the CFA has an associated color ADC. Optionally, the pixel values of the color ADCs associated with the CFA are combined to produce a color image. Optionally, the pixel values associated with the red, green, and blue ADCs are multiplied by 0.271, 0.589, and 0.0073, respectively, and combined with the pixel value from the monochrome ADCs of the associated monochrome photodiodes to produce an enhanced monochrome image. In still another aspect, a conversion factor for each color is determined according to the environmental lighting conditions and the pixel value from a first monochrome ADCs is divided by a red conversion factor and combined with the pixel value from the associated red ADC, the pixel value from a second monochrome ADC is divided by a green conversion factor and combined with the pixel value from the associated green ADC, and the pixel value from a third monochrome ADC is divided by a blue conversion factor and combined with the pixel value from the associated blue ADC to produce an enhanced color image.

According to a further aspect of the present invention there is provided a method performed using a sensor apparatus comprising a controller, a memory, and a plurality of photodiodes, including one or more color photodiodes each including a chromatic filter; a color-select switch; and having at least one associated monochrome photodiode with a monochrome filter and a monochrome-select switch; and being connected to an analog-to-digital converter (ADC), the method comprising arranging the color photodiodes and the monochrome photodiodes according to an arrangement; converting, by the photodiodes, incoming light to charge; converting, by a charge storage device, the charge to a voltage; generating, using the ADCs corresponding to the color photodiodes a pixel value for one or more color photodiodes via the respective color-select switch; and generating, using the ADCs corresponding to the monochrome photodiodes a pixel value for one or more monochrome photodiodes via the respective monochrome-select switch.

Optionally, the arrangement comprises a first row including a repeating pattern of color and monochrome photodiodes and a second row including a repeating pattern of color and monochrome photodiodes, wherein successive rows of the arrangement alternate between the first and second rows. Optionally, the repeating pattern of the first row includes photodiodes with filters having the sequence: red, monochrome, green, monochrome and the repeating pattern of the second row includes photodiodes with filters having the sequence: green, monochrome, blue, monochrome.

Optionally, the arrangement comprises a third row including a repeating pattern of color and monochrome photodiodes and a fourth row including a repeating pattern of monochrome and color photodiodes, wherein successive rows of the arrangement alternate between the third and fourth rows. In another aspect, the repeating pattern of the third row includes photodiodes with filters having the sequence: red, monochrome, green, monochrome and the repeating pattern of the fourth row includes photodiodes with filters having the sequence: monochrome, green, monochrome, blue.

Optionally, the arrangement includes at least one color photodiode adjacent to at least one monochrome photodiode.

These illustrative examples are mentioned not to limit or define the scope of this disclosure, but rather to provide examples to aid understanding thereof. Illustrative examples are discussed in the Detailed Description, which provides further description. Advantages offered by various examples may be further understood by examining this specification.

### BRIEF DESCRIPTION OF THE DRAWINGS

The accompanying drawings, which are incorporated into and constitute a part of this specification, illustrate one or more certain examples and, together with the description of the example, serve to explain the principles and implementations of the certain examples.
FIG. 1A and FIG. 1B are diagrams of an embodiment of a near-eye display.
FIG. 2 is an embodiment of a cross section of the near-eye display.
FIG. 3 illustrates an isometric view of an embodiment of a waveguide display with a single source assembly.
FIG. 4 illustrates a cross section of an embodiment of the waveguide display.
FIG. 5 is a block diagram of an embodiment of a system including the near-eye
FIG. 6 illustrates an example of an image sensor that can include a dual pixel array.
FIGS. 7A-7C, illustrate examples of operations of an image sensor for 2D and 3D imaging that can include a dual pixel array.
FIGS. 8A-8E illustrate examples of arrangements of photodiodes in an image sensor that may include a dual pixel array.
FIG. 9 illustrates an example of pixel array for providing a dual pixel structure.
FIG. 10 illustrates an example pixel array for providing a dual pixel structure.
FIGS. 11A-B illustrate two example arrangements of pixels in a dual pixel array.
FIGS. 12A-B show example timing diagrams for an example pixel sensor containing a dual pixel array.
FIG. 13 illustrates an example method for obtaining monochrome and color images from a dual pixel array.
FIG. 14 illustrates an example method for enhancing monochrome images information captured from the color channels.

### DETAILED DESCRIPTION

Examples are described herein in the context of providing a pixel sensor using a dual pixel array. Those of ordinary skill in the art will realize that the following description is illustrative only and is not intended to be in any way limiting. Reference will now be made in detail to implementations of examples as illustrated in the accompanying drawings. The same reference indicators will be used throughout the drawings and the following description to refer to the same or like items.

In the interest of clarity, not all of the routine features of the examples described herein are shown and described. It will, of course, be appreciated that in the development of any such actual implementation, numerous implementation-specific decisions must be made in order to achieve the developer's specific goals, such as compliance with application- and business-related constraints, and that these specific goals will vary from one implementation to another and from one developer to another.

A typical image sensor includes an array of pixel cells. Each pixel cell includes a photodiode to sense incident light by converting photons into charge (e.g., electrons or holes). The charge generated by photodiodes of the array of pixel cells can then be quantized by an analog-to-digital converter (ADC) into digital values. The ADC can quantize the charge by, for example, using a comparator to compare a voltage representing the charge with one or more quantization levels, and a digital value can be generated based on the comparison result. The digital values can then be stored in a memory to generate a digital image.

The digital image data can support various wearable applications, such as object recognition and tracking, location tracking, augmented reality (AR), virtual reality (VR), mixed reality (MR), etc. These and other applications may utilize extraction techniques to extract, from a subset of pixels of the digital image, aspects of the digital image (i.e., light levels, scenery, semantic regions) and/or features of the digital image (i.e., objects and entities represented in the digital image). For example, an application can identify pixels of reflected structured light (e.g., dots), compare a pattern extracted from the pixels with the transmitted structured light, and perform depth computation based on the comparison.

The application can also identify 2D pixel data from the same pixel cells that provide the extracted pattern of structured light to perform fusion of 2D and 3D sensing. To perform object recognition and tracking, an application can also identify pixels of image features of the object, extract the image features from the pixels, and perform the recognition and tracking based on the extraction results. These applications are typically executed on a host processor, which can be electrically connected with the image sensor and receive the pixel data via interconnects. The host processor, the image sensor, and the interconnects can be part of a wearable device.

Modern MR devices utilize multiple cameras to capture a virtual scene over a physical space to a user of a wearable device. For example, at least four cameras may be used in some MR devices. Cameras can include image sensors that may be either color or monochrome, depending on the application. Monochrome and color sensors differ primarily in that color sensors include a chromatic filter that must be penetrated by incident light prior to reaching the pixel array. The chromatic filter can be used to capture photons of several specific wavelengths at different pixel locations to create a composite color image using, for example, a color filter array, whereas a monochrome sensor may capture all photons or all photons of a large wavelength band.

Monochrome sensors may be useful in applications that require greater detail and sensitivity including, for example, computer vision tasks. For example, a monochrome Simultaneous Localization and Mapping ("SLAM") camera may be used for placement and transforming digital objects relative to real-world objects. A monochrome hand tracking ("HT") camera may be used for mapping human hand, arm, or limb movements to the rendered scene to enable users to interface with objects in the scene using a virtual hand or other suitable user interface. A monochrome near-infrared depth camera can be used to measure the depth of physical objects in the vicinity of the user of the wearable device. For instance, the wearable device may project a near-infrared pattern using an illuminator onto physical objects in the vicinity of the user of the wearable device, which are reflected and can be captured by the depth camera. In some examples, one monochrome camera can be used for multiple applications. For instance, a single monochrome camera may be used for SLAM, HT, and depth-sensing.

Likewise, a color (e.g., RGB) camera can be used in MR applications to capture the physical scene in the vicinity of the user of the wearable device. The physical scene can then be directly displayed or rendered as a virtual scene with chromatic fidelity using the color data captured by the image sensor in the color camera.

In order to capture all of the data needed for providing MR to the user of the wearable device, both color and monochrome cameras may be required. However, space is at a premium in modern wearable devices. Substantial engineering investments may be required to miniaturize the two cameras, which may result in undesired compromises in design features. Moreover, because two cameras located at different locations are used to capture the same physical space, complex calibrations and continuous transformations may be required to map the pixels captured on one camera to another in real-time.

This disclosure relates to a "dual pixel" array that incorporates both monochrome and color camera functions into a single pixel array. In this context, "dual pixel" refers to a pixel array including a plurality of photodiodes in which each color photodiode has at least one corresponding monochrome photodiode located on the array. For example, one arrangement of photodiodes may include a monochrome photodiode adjacent to every color photodiode. Data can be read out from one or more color channels and a monochrome channel in parallel. In this way, both color and monochrome images may be simultaneously obtained from the same pixel array to support the disparate applications of the two camera types, while reducing the need for calibration or transformation of the two images due to images obtained from different locations.

To enable a configurable image sensor that supports a dual pixel structure, an example image sensor includes an array of pixels that each have a plurality of light-sensing elements, such as photodiodes, that are each connected to one or more charge storage devices. A pixel in this context refers to a sensor pixel which may include one or more photodiodes or sub-pixels. In contrast, one or more sensor pixels may correspond to a pixel in an image file or image pixel. The charge storage devices of each of the photodiodes are connected to one or more ADCs, a memory, a controller, and a select switch.

In one example, each pixel may include a charge sensing unit shared between the plurality of photodiodes. The charge sensing unit may include a charge storage device (e.g., a floating drain node, a capacitor, etc.) to temporarily store the charge generated by the photodiodes and convert the charge to voltages. The one or more charge sensing units may include a single charge sensing unit which can be shared among the plurality of photodiodes to perform charge-to-voltage conversion. In one example, the one or more charge sensing units may include a plurality of charge sensing units each corresponding to a photodiode of the plurality of photodiodes and configured to convert the charge generated by the respective photodiode to a voltage. In both examples, the pixel further includes a plurality of switches, with each switch coupled between a photodiode and the shared/corresponding charge sensing unit, which can be controlled by the controller to control the transfer of the charge from the photodiode to the charge sensing unit. In a case where the one or more ADCs are shared among the plurality of charge sensing units, each charge sensing unit can also include a switch coupled between a buffer and the one or more ADCs which can be controlled by the controller to select which of the charge sensing units to provide an output voltage to the one or more ADCs.

The controller can control the one or more ADCs to quantize the output voltages output by the one or more charge sensing units. The one or more ADCs can be shared between the charge sensing units (in a case where the pixel cell includes multiple charge sensing units) or may include a single ADC coupled with a single charge sensing unit of the pixel cell.

Each photodiode of the plurality of photodiodes is configured to convert a component of incident light to charge. The controller can transfer the charge from the plurality of photodiodes to the one or more charge sensing units to convert to voltages. The controller can also control the ADCs to perform a quantization process to quantize the voltages from the one or more charge sensing units to digital values representing components of a pixel, which can correspond to a spot of the scene. The controller can also store at least some of the digital values in the memory and generate a pixel value based on the at least some of the digital values stored in the memory. The pixel values from the array of the pixel cells can represent the incident light received by each pixel cell within a global exposure period to support a global shutter operation. In the global shutter operation, each photodiode of the array of photodiodes senses the incident light simultaneously in a global exposure period to generate the charge. To affect the global shutter operation, the integration period (time during which light is collected) for each photodiode of the array of photodiodes begins and ends at the same time.

In some examples, pixel values can be read out one row at a time to support a rolling shutter operation. For example, at a first time instant, pixels on one row of the pixel array may be reset, pixels on a second row may be exposed to light signals to accumulate charges on each pixel, and voltage signals from pixels on a third row may be read out and converted into a digital signal by a set of ADCs. The rest of the pixels in the pixel array may be deactivated and may not consume any electrical power at the first time instant. The window that includes the row of pixels being reset, the row(s) of pixels being exposed to light, and the row of pixels being read may be shifted down one row at a time to generate the image frame.

In some examples, the plurality of photodiodes can be arranged laterally and having the same distance from the light receiving surface, with each photodiode corresponding to a sub-pixel and configured to receive incident light from the same spot of the scene. A filter array can be positioned on a first side of the light receiving surface of the pixel cell. The filter array may include filter elements positioned at a plurality of locations on the first side of the light receiving surface to set a component of the incident light that enters the light receiving surface at the respective location. The plurality of photodiodes can be in a single semiconductor substrate and positioned at the plurality of locations on a second side of the light receiving surface to receive the respective components of the incident light. In some examples, one or more microlenses can be positioned over the filter array to project the incident light received from that same spot of the scene towards the plurality of locations on the first side of the light receiving surface, such that each photodiode, as a sub-pixel, can receive incident light from that same spot.

The plurality of photodiodes thus configured can be arranged according to an arrangement. The arrangement specifies the layout of the color and monochrome photodiodes on the dual pixel array. In the dual pixel array, each color photodiode can have at least one associated monochrome photodiode located on the array. The associated photodiodes may be adjacent or may be relatively arranged according to any pattern. In some embodiments, there may be more than one monochrome photodiode associated with each color photodiode. An example arrangement may one in which a first row includes photodiodes with filters having the sequence: red, monochrome, green, monochrome and a second row includes photodiodes with filters having the sequence: green, monochrome, blue, monochrome. The patterns in the first and second rows then repeat, within each row, and each row repeats the first and second rows, alternating until the bottom of the pixel array is reached.

In order to capture an image simultaneously using the monochrome photodiodes and the color photodiodes, the monochrome and color channels must be read out separately and substantially simultaneously. Thus, circuitry must be provided to select individual pixels or groups of pixels (e.g., all green photodiodes or all monochrome photodiodes) at a time. To allow individual pixels to be selected for ADC operations, monochrome-select and color-select switches are included for each row or column of pixels that can be selectively enabled or disabled to allow stored charge or voltage from the pixel to be transferred to the ADC circuitry for conversion.

During an exposure period, each pixel's photodiode captures incoming light and converts it to an electric charge which is stored in the charge storage device, e.g., a floating diffusion ("FD") region. During quantization, monochrome or color select signals are transmitted to some (or all) of the pixels in the sensor to select a particular channel (for global shutter) or portion of a channel (for rolling shutter) for conversion to a digital value. However, because multiple pixels may share the same ADC circuitry, multiple monochrome or color select signals may be sent in sequence to select different pixels within the dual pixel array for conversion within a single quantization period. In some other examples, the dual pixel array may include duplicate circuitry for the color and monochrome pixels, which may support substantially simultaneous readout of color and monochrome channels.

Thus, in operation, after the exposure period completes, quantization begins and a set of pixels are selected by enabling a set of monochrome or color select lines. The charge or voltage at the selected pixels are converted to pixel values, which are stored and then read out. For example, all color pixels may be read out at the same time that all monochrome pixels are simultaneously read out. If additional pixels are to be read out, additional conversion operations occur by enabling different sets of monochrome and color select lines, followed by ADC, storage, and read-out operations. Once all pixels to be converted have been read out, the pixels are reset and the next exposure period begins.

The color channels can be combined to form a composite color image to be projected, for example, as the backdrop for an MR display on a wearable device. The monochrome channel can be used for the same environment for 3D computer vision tasks. In addition, because the color and monochrome photodiodes are located on the same sensor, one or more color channels can be merged with the monochrome channel to enhance low-light performance of the color camera or to simulate a monochrome signal using the color channels.

This dual pixel array configuration can have several benefits. Only a single pixel array is needed, which substantially reduces the footprint of the optical sensors needed for MR operations. Instead of two cameras, only a single camera with the dual pixel array is required. Importantly, because the color and monochrome pixels are nearly co-located, the spatial correlation between the two pixels is almost identical, which can result in significantly simplified requirements for calibration and real-time transformation and thus reduced processing power requirements. Additionally, the monochrome channel can be read out concurrently with or nearly-concurrently with the RGB channels and can be used to enhance the sensitivity or resolution of the color camera. Likewise, the color channels may be enhanced with information from the monochrome channel using a similar procedure.

For example, the monochrome camera can be used to enhance the low-light performance of the color camera. Because the monochrome channel is effectively an integration over all visible wavelengths, or a subset thereof, the monochrome signal may be up to 200% greater than the integrated color signal. A low-light color signal can be boosted by adding a fraction of the monochrome channel to one or more color channels. The fraction, which can be used to determine one or more multipliers, can vary according to environmental lighting conditions.

In another example, the color channels can be used to create an effective monochrome channel when the monochrome signal is unavailable. In one example dual pixel array using red, green, and blue color photodiodes, the red channel can be multiplied by 0.271, the green channel can be multiplied by 0.589, and the blue channel can be multiplied by 0.0073, and the resultant products can be combined to produce a synthetic monochrome channel. This straightforward combination of channels is possible because in the dual pixel array structure, associated color and monochrome photodiodes are close together on the same sensor array.

In addition, co-location of color and monochrome pixels on the same can result in improved thermal correlation between color and monochrome images. In certain embodiments, color and monochrome pixels may be adjacent or closely spaced such that they can share a microlens. Because the ambient temperature affects the focusing characteristics of the microlens, additional calibration may be needed to map a monochrome image obtained at one temperature to a color image obtained at a different temperature, when the sensors are not co-located. In the dual pixel array, the need for extensive thermal calibration is lessened because the monochrome and color sensors are closer and thus closer to a mutual thermal equilibrium, and in some cases, may share a microlens and thus be affected by the temperature in the same way.

This illustrative example is given to introduce the reader to the general subject matter discussed herein and the disclosure is not limited to this example. The following sections describe various additional non-limiting examples for providing a pixel sensor with a dual pixel array.

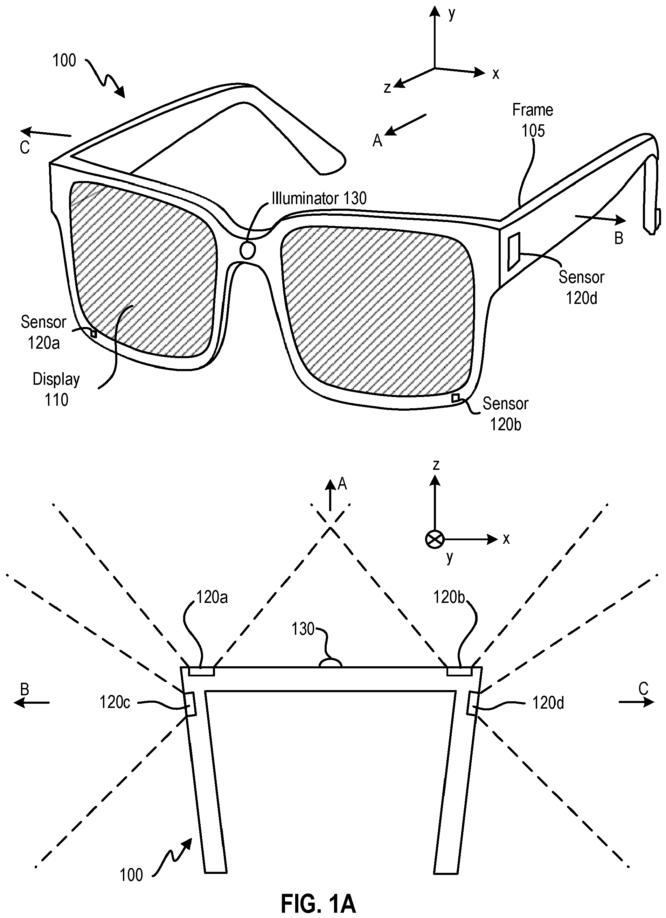

FIG. 1A is a diagram of an embodiment of a near-eye display 100. Near-eye display 100 presents media to a user. Examples of media presented by near-eye display 100 include one or more images, video, and/or audio. In some embodiments, audio is presented via an external device (e.g., speakers and/or headphones) that receives audio information from the near-eye display 100, a console, or both, and presents audio data based on the audio information. Near-eye display 100 is generally configured to operate as a virtual reality (VR) display. In some embodiments, near-eye display 100 is modified to operate as an augmented reality (AR) display and/or a mixed reality (MR) display.

Near-eye display 100 includes a frame 105 and a display 110. Frame 105 is coupled to one or more optical elements. Display 110 is configured for the user to see content presented by near-eye display 100. In some embodiments, display 110 comprises a waveguide display assembly for directing light from one or more images to an eye of the user.

Near-eye display 100 further includes image sensors 120a, 120b, 120c, and 120d. Each of image sensors 120a, 120b, 120c, and 120d may include a pixel array configured to generate image data representing different fields of views along different directions. For example, sensors 120a and 120b may be configured to provide image data representing two fields of view towards a direction A along the Z axis, whereas sensor 120c may be configured to provide image data representing a field of view towards a direction B along the X axis, and sensor 120d may be configured to provide image data representing a field of view towards a direction C along the X axis.

In some embodiments, sensors 120a-120d can be configured as input devices to control or influence the display content of the near-eye display 100 to provide an interactive VR/AR/MR experience to a user who wears near-eye display 100. For example, sensors 120a-120d can generate physical image data of a physical environment in which the user is located. The physical image data can be provided to a location tracking system to track a location and/or a path of movement of the user in the physical environment. A system can then update the image data provided to display 110 based on, for example, the location and orientation of the user, to provide the interactive experience. In some embodiments, the location tracking system may operate a SLAM algorithm to track a set of objects in the physical environment and within a view of field of the user as the user moves within the physical environment. The location tracking system can construct and update a map of the physical environment based on the set of objects, and track the location of the user within the map. By providing image data corresponding to multiple fields of views, sensors 120a-120d can provide the location tracking system a more holistic view of the physical environment, which can lead to more objects to be included in the construction and updating of the map. With such an arrangement, the accuracy and robustness of tracking a location of the user within the physical environment can be improved.

In some embodiments, near-eye display 100 may further include one or more active illuminators 130 to project light into the physical environment. The light projected can be associated with different frequency spectrums (e.g., visible light, infra-red light, ultra-violet light), and can serve various purposes. For example, illuminator 130 may project light in a dark environment (or in an environment with low intensity of infra-red light, ultra-violet light, etc.) to assist sensors 120a-120d in capturing images of different objects within the dark environment to, for example, enable location tracking of the user. Illuminator 130 may project certain markers onto the objects within the environment, to assist the location tracking system in identifying the objects for map construction/updating.

In some embodiments, illuminator 130 may also enable stereoscopic imaging. For example, one or more of sensors 120a or 120b can include both a first pixel array for visible light sensing and a second pixel array for infra-red (IR) light sensing. The first pixel array can be overlaid with a color filter (e.g., a Bayer filter), with each pixel of the first pixel array being configured to measure intensity of light associated with a particular color (e.g., one of red, green or blue colors). The second pixel array (for IR light sensing) can also be overlaid with a filter that allows only IR light through, with each pixel of the second pixel array being configured to measure intensity of IR lights. The pixel arrays can generate an RGB image and an IR image of an object, with each pixel of the IR image being mapped to each pixel of the RGB image. Illuminator 130 may project a set of IR markers on the object, the images of which can be captured by the IR pixel array. Based on a distribution of the IR markers of the object as shown in the image, the system can estimate a distance of different parts of the object from the IR pixel array, and generate a stereoscopic image of the object based on the distances. Based on the stereoscopic image of the object, the system can determine, for example, a relative position of the object with respect to the user, and can update the image data provided to display 100 based on the relative position information to provide the interactive experience.

As discussed above, near-eye display 100 may be operated in environments associated with a very wide range of light intensities. For example, near-eye display 100 may be operated in an indoor environment or in an outdoor environment, and/or at different times of the day. Near-eye display 100 may also operate with or without active illuminator 130 being turned on. As a result, image sensors 120a-120d may need to have a wide dynamic range to be able to operate properly (e.g., to generate an output that correlates with the intensity of incident light) across a very wide range of light intensities associated with different operating environments for near-eye display 100.

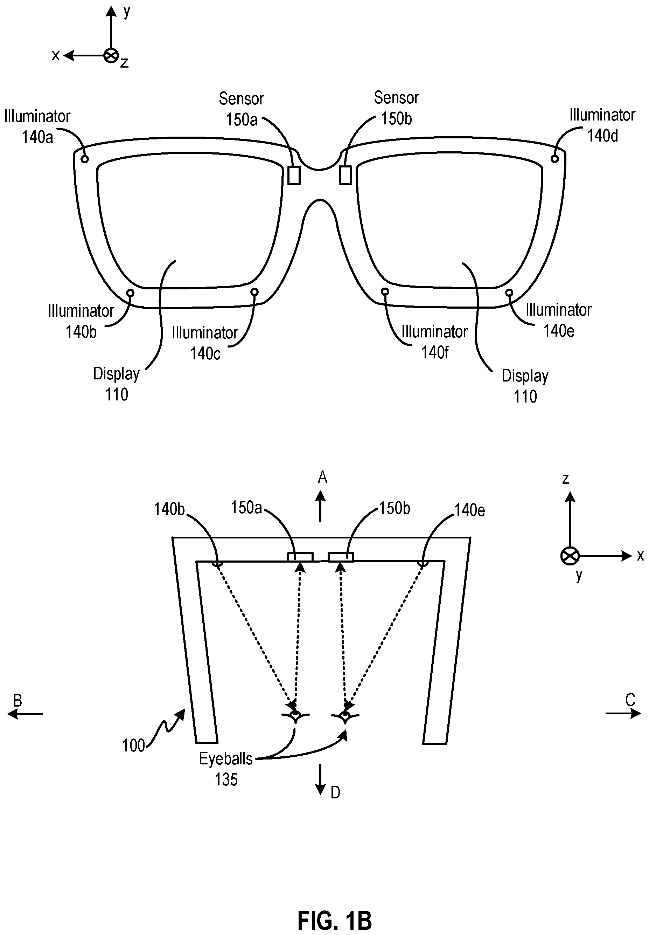

FIG. 1B is a diagram of another embodiment of near-eye display 100. FIG. 1B illustrates a side of near-eye display 100 that faces the eyeball(s) 135 of the user who wears near-eye display 100. As shown in FIG. 1B, near-eye display 100 may further include a plurality of illuminators 140a, 140b, 140c, 140d, 140e, and 140f. Near-eye display 100 further includes a plurality of image sensors 150a and 150b. Illuminators 140a, 140b, and 140c may emit lights of certain frequency range (e.g., NIR) towards direction D (which is opposite to direction A of FIG. 1A). The emitted light may be associated with a certain pattern, and can be reflected by the left eyeball of the user. Sensor 150a may include a pixel array to receive the reflected light and generate an image of the reflected pattern. Similarly, illuminators 140d, 140e, and 140f may emit NIR lights carrying the pattern. The NIR lights can be reflected by the right eyeball of the user, and may be received by sensor 150b. Sensor 150b may also include a pixel array to generate an image of the reflected pattern. Based on the images of the reflected pattern from sensors 150a and 150b, the system can determine a gaze point of the user, and update the image data provided to display 100 based on the determined gaze point to provide an interactive experience to the user.

As discussed above, to avoid damaging the eyeballs of the user, illuminators 140a, 140b, 140c, 140d, 140e, and 140f are typically configured to output lights of very low intensities. In a case where image sensors 150a and 150b comprise the same sensor devices as image sensors 120a-120d of FIG. 1A, the image sensors 120a-120d may need to be able to generate an output that correlates with the intensity of incident light when the intensity of the incident light is very low, which may further increase the dynamic range requirement of the image sensors.

Moreover, the image sensors 120a-120d may need to be able to generate an output at a high speed to track the movements of the eyeballs. For example, a user's eyeball can perform a very rapid movement (e.g., a saccade movement) in which there can be a quick jump from one eyeball position to another. To track the rapid movement of the user's eyeball, image sensors 120a-120d need to generate images of the eyeball at high speed. For example, the rate at which the image sensors generate an image frame (the frame rate) needs to at least match the speed of movement of the eyeball. The high frame rate requires short total exposure time for all of the pixel cells involved in generating the image frame, as well as high speed for converting the sensor outputs into digital values for image generation. Moreover, as discussed above, the image sensors also need to be able to operate at an environment with low light intensity.

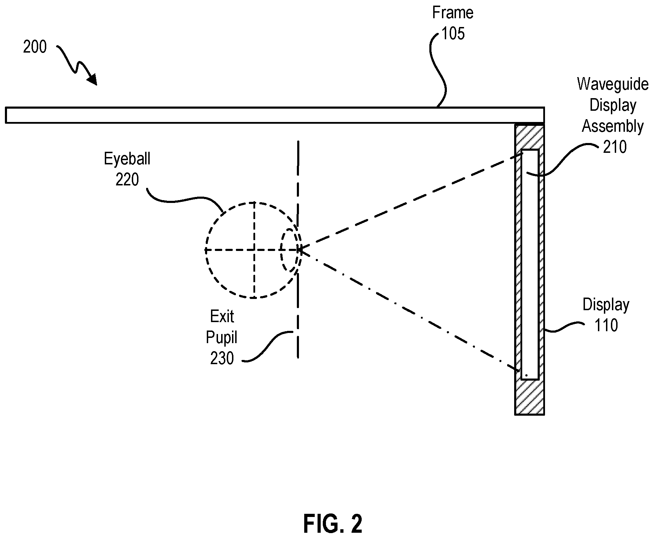

FIG. 2 is an embodiment of a cross section 200 of near-eye display 100 illustrated in FIG. 1. Display 110 includes at least one waveguide display assembly 210. An exit pupil 230 is a location where a single eyeball 220 of the user is positioned in an eyebox region when the user wears the near-eye display 100. For purposes of illustration, FIG. 2 shows the cross section 200 associated eyeball 220 and a single waveguide display assembly 210, but a second waveguide display is used for a second eye of a user.

Waveguide display assembly 210 is configured to direct image light to an eyebox located at exit pupil 230 and to eyeball 220. Waveguide display assembly 210 may be composed of one or more materials (e.g., plastic, glass) with one or more refractive indices. In some embodiments, near-eye display 100 includes one or more optical elements between waveguide display assembly 210 and eyeball 220.

In some embodiments, waveguide display assembly 210 includes a stack of one or more waveguide displays including, but not restricted to, a stacked waveguide display, a varifocal waveguide display, etc. The stacked waveguide display is a polychromatic display (e.g., a red-green-blue (RGB) display) created by stacking waveguide displays whose respective monochromatic sources are of different colors. The stacked waveguide display is also a polychromatic display that can be projected on multiple planes (e.g., multi-planar colored display). In some configurations, the stacked waveguide display is a monochromatic display that can be projected on multiple planes (e.g., multi-planar monochromatic display). The varifocal waveguide display is a display that can adjust a focal position of image light emitted from the waveguide display. In alternate embodiments, waveguide display assembly 210 may include the stacked waveguide display and the varifocal waveguide display.

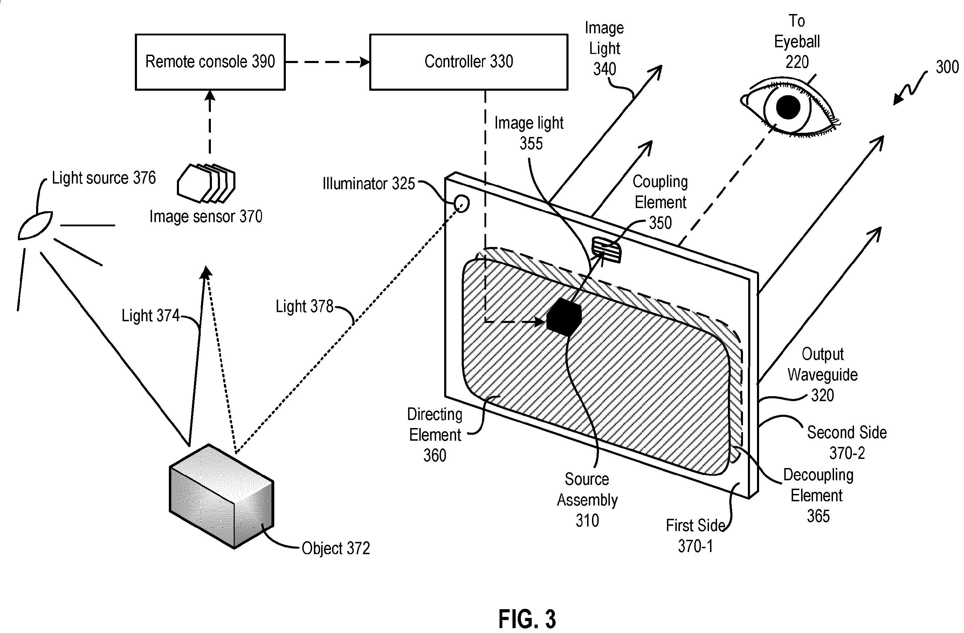

FIG. 3 illustrates an isometric view of an embodiment of a waveguide display 300 with a single source assembly. In some embodiments, waveguide display 300 is a component (e.g., waveguide display assembly 210) of near-eye display 100. In some embodiments, waveguide display 300 is part of some other near-eye display or other system that directs image light to a particular location.

Waveguide display 300 includes a source assembly 310, an output waveguide 320, and a controller 330. For purposes of illustration, FIG. 3 shows the waveguide display 300 associated with a single eyeball 220, but in some embodiments, another waveguide display separate, or partially separate, from the waveguide display 300 provides image light to another eye of the user.

Source assembly 310 generates and outputs image light 355 to a coupling element 350 located on a first side 370-1 of output waveguide 320. Output waveguide 320 is an optical waveguide that outputs expanded image light 340 to an eyeball 220 of a user. Output waveguide 320 receives image light 355 at one or more coupling elements 350 located on the first side 370-1 and guides received input image light 355 to a directing element 360. In some embodiments, coupling element 350 couples the image light 355 from source assembly 310 into output waveguide 320. Coupling element 350 may be, e.g., a diffraction grating, a holographic grating, one or more cascaded reflectors, one or more prismatic surface elements, and/or an array of holographic reflectors.

Directing element 360 redirects the received input image light 355 to decoupling element 365 such that the received input image light 355 is decoupled out of output waveguide 320 via decoupling element 365. Directing element 360 is part of, or affixed to, first side 370-1 of output waveguide 320. Decoupling element 365 is part of, or affixed to, second side 370-2 of output waveguide 320, such that directing element 360 is opposed to the decoupling element 365. Directing element 360 and/or decoupling element 365 may be, e.g., a diffraction grating, a holographic grating, one or more cascaded reflectors, one or more prismatic surface elements, and/or an array of holographic reflectors.

Second side 370-2 represents a plane along an x-dimension and a y-dimension. Output waveguide 320 may be composed of one or more materials that facilitate total internal reflection of image light 355. Output waveguide 320 may be composed of e.g., silicon, plastic, glass, and/or polymers. Output waveguide 320 has a relatively small form factor. For example, output waveguide 320 may be approximately 50 mm wide along x-dimension, 30 mm long along y-dimension and 0.5-1 mm thick along a z-dimension.

Controller 330 controls scanning operations of source assembly 310. The controller 330 determines scanning instructions for the source assembly 310. In some embodiments, the output waveguide 320 outputs expanded image light 340 to the user's eyeball 220 with a large field of view (FOV). For example, the expanded image light 340 is provided to the user's eyeball 220 with a diagonal FOV (in x and y) of 60 degrees and/or greater and/or 150 degrees and/or less. The output waveguide 320 is configured to provide an eyebox with a length of 20 mm or greater and/or equal to or less than 50 mm; and/or a width of 10 mm or greater and/or equal to or less than 50 mm.

Moreover, controller 330 also controls image light 355 generated by source assembly 310, based on image data provided by image sensor 370. Image sensor 370 may be located on first side 370-1 and may include, for example, image sensors 120a-120d of FIG. 1A. Image sensors 120a-120d can be operated to perform 2D sensing and 3D sensing of, for example, an object 372 in front of the user (e.g., facing first side 370-1). For 2D sensing, each pixel cell of image sensors 120a-120d can be operated to generate pixel data representing an intensity of light 374 generated by a light source 376 and reflected off object 372. For 3D sensing, each pixel cell of image sensors 120a-120d can be operated to generate pixel data representing a time-of-flight measurement for light 378 generated by illuminator 325. For example, each pixel cell of image sensors 120a-120d can determine a first time when illuminator 325 is enabled to project light 378 and a second time when the pixel cell detects light 378 reflected off object 372. The difference between the first time and the second time can indicate the time-of-flight of light 378 between image sensors 120a-120d and object 372, and the time-of-flight information can be used to determine a distance between image sensors 120a-120d and object 372. Image sensors 120a-120d can be operated to perform 2D and 3D sensing at different times, and provide the 2D and 3D image data to a remote console 390 that may be (or may not be) located within waveguide display 300. The remote console may combine the 2D and 3D images to, for example, generate a 3D model of the environment in which the user is located, to track a location and/or orientation of the user, etc. The remote console may determine the content of the images to be displayed to the user based on the information derived from the 2D and 3D images. The remote console can transmit instructions to controller 330 related to the determined content. Based on the instructions, controller 330 can control the generation and outputting of image light 355 by source assembly 310, to provide an interactive experience to the user.

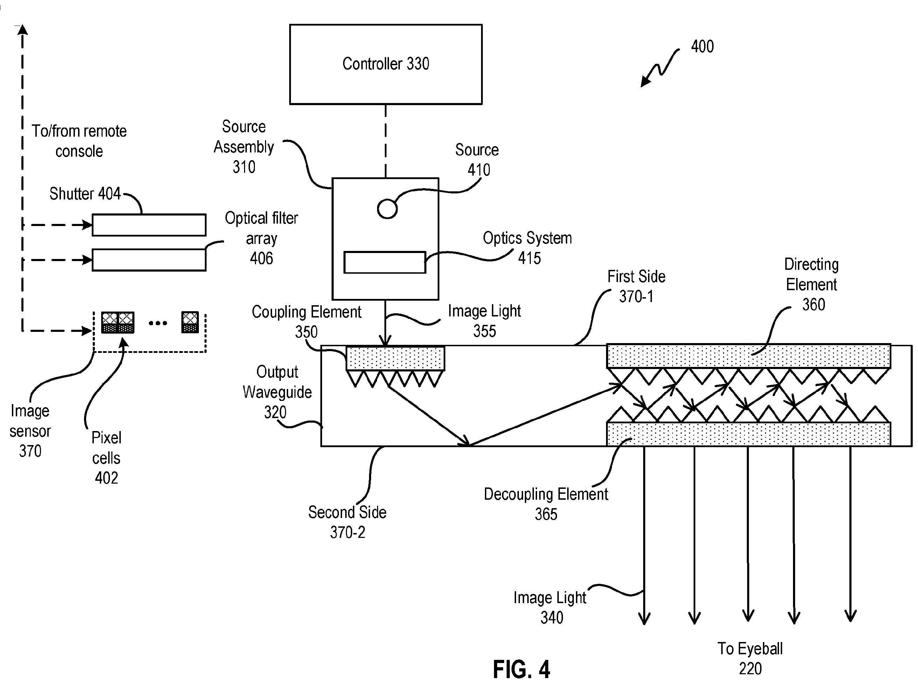

FIG. 4 illustrates an embodiment of a cross section 400 of the waveguide display 300. The cross section 400 includes source assembly 310, output waveguide 320, and image sensor 370. In the example of FIG. 4, image sensor 370 may include a set of pixel cells 402 located on first side 370-1 to generate an image of the physical environment in front of the user. In some embodiments, there can be a mechanical shutter 404 and an optical filter array 406 interposed between the set of pixel cells 402 and the physical environment. Mechanical shutter 404 can control the exposure of the set of pixel cells 402. In some embodiments, the mechanical shutter 404 can be replaced by an electronic shutter gate, as to be discussed below. Optical filter array 406 can control an optical wavelength range of light the set of pixel cells 402 is exposed to, as to be discussed below. Each of pixel cells 402 may correspond to one pixel of the image. Although not shown in FIG. 4, it is understood that each of pixel cells 402 may also be overlaid with a filter to control the optical wavelength range of the light to be sensed by the pixel cells.

After receiving instructions from the remote console, mechanical shutter 404 can open and expose the set of pixel cells 402 in an exposure period. During the exposure period, image sensor 370 can obtain samples of lights incident on the set of pixel cells 402, and generate image data based on an intensity distribution of the incident light samples detected by the set of pixel cells 402. Image sensor 370 can then provide the image data to the remote console, which determines the display content, and provide the display content information to controller 330. Controller 330 can then determine image light 355 based on the display content information.

Source assembly 310 generates image light 355 in accordance with instructions from the controller 330. Source assembly 310 includes a source 410 and an optics system 415. Source 410 is a light source that generates coherent or partially coherent light. Source 410 may be, e.g., a laser diode, a vertical cavity surface emitting laser, and/or a light emitting diode.

Optics system 415 includes one or more optical components that condition the light from source 410. Conditioning light from source 410 may include, e.g., expanding, collimating, and/or adjusting orientation in accordance with instructions from controller 330. The one or more optical components may include one or more lenses, liquid lenses, mirrors, apertures, and/or gratings. In some embodiments, optics system 415 includes a liquid lens with a plurality of electrodes that allows scanning of a beam of light with a threshold value of scanning angle to shift the beam of light to a region outside the liquid lens. Light emitted from the optics system 415 (and also source assembly 310) is referred to as image light 355.

Output waveguide 320 receives image light 355. Coupling element 350 couples image light 355 from source assembly 310 into output waveguide 320. In embodiments where coupling element 350 is a diffraction grating, a pitch of the diffraction grating is chosen such that total internal reflection occurs in output waveguide 320, and image light 355 propagates internally in output waveguide 320 (e.g., by total internal reflection), toward decoupling element 365.

Directing element 360 redirects image light 355 toward decoupling element 365 for decoupling from output waveguide 320. In embodiments where directing element 360 is a diffraction grating, the pitch of the diffraction grating is chosen to cause incident image light 355 to exit output waveguide 320 at angle(s) of inclination relative to a surface of decoupling element 365.

In some embodiments, directing element 360 and/or decoupling element 365 are structurally similar. Expanded image light 340 exiting output waveguide 320 is expanded along one or more dimensions (e.g., may be elongated along x-dimension). In some embodiments, waveguide display 300 includes a plurality of source assemblies 310 and a plurality of output waveguides 320. Each of source assemblies 310 emits a monochromatic image light of a specific band of wavelength corresponding to a primary color (e.g., red, green, or blue). Each of output waveguides 320 may be stacked together with a distance of separation to output an expanded image light 340 that is multi-colored.

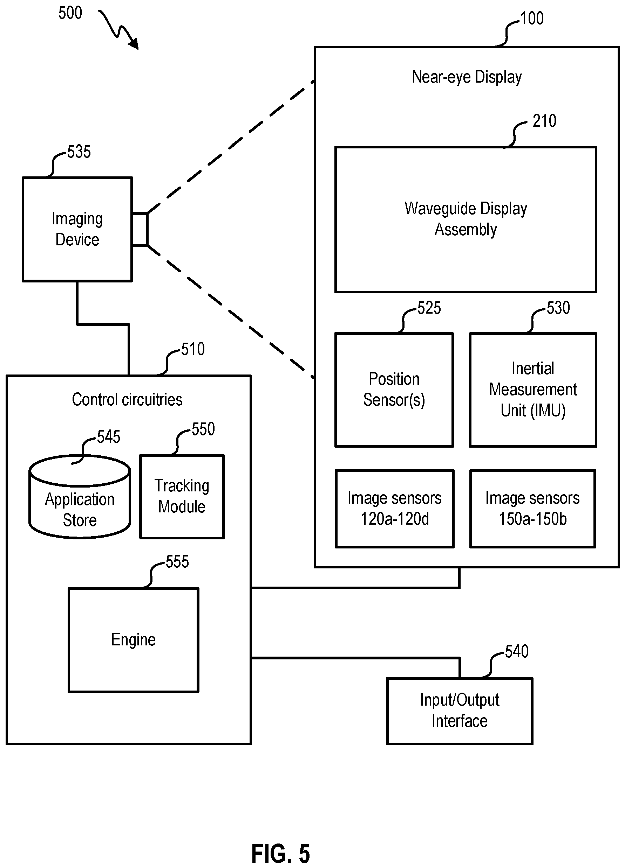

FIG. 5 is a block diagram of an embodiment of a system 500 including the near-eye display 100. The system 500 comprises near-eye display 100, an imaging device 535, an input/output interface 540, and image sensors 120a-120d and 150a-150b that are each coupled to control circuitries 510. System 500 can be configured as a head-mounted device, a mobile device, a wearable device, etc.

Near-eye display 100 is a display that presents media to a user. Examples of media presented by the near-eye display 100 include one or more images, video, and/or audio. In some embodiments, audio is presented via an external device (e.g., speakers and/or headphones) that receives audio information from near-eye display 100 and/or control circuitries 510 and presents audio data based on the audio information to a user. In some embodiments, near-eye display 100 may also act as an AR eyewear glass. In some embodiments, near-eye display 100 augments views of a physical, real-world environment, with computer-generated elements (e.g., images, video, sound).

Near-eye display 100 includes waveguide display assembly 210, one or more position sensors 525, and/or an inertial measurement unit (IMU) 530. Waveguide display assembly 210 includes source assembly 310, output waveguide 320, and controller 330.

IMU 530 is an electronic device that generates fast calibration data indicating an estimated position of near-eye display 100 relative to an initial position of near-eye display 100 based on measurement signals received from one or more of position sensors 525.

Imaging device 535 may generate image data for various applications. For example, imaging device 535 may generate image data to provide slow calibration data in accordance with calibration parameters received from control circuitries 510. Imaging device 535 may include, for example, image sensors 120a-120d of FIG. 1A for generating image data of a physical environment in which the user is located for performing location tracking of the user. Imaging device 535 may further include, for example, image sensors 150a-150b of FIG. 1B for generating image data for determining a gaze point of the user to identify an object of interest of the user.

The input/output interface 540 is a device that allows a user to send action requests to the control circuitries 510. An action request is a request to perform a particular action. For example, an action request may be to start or end an application or to perform a particular action within the application.

Control circuitries 510 provide media to near-eye display 100 for presentation to the user in accordance with information received from one or more of: imaging device 535, near-eye display 100, and input/output interface 540. In some examples, control circuitries 510 can be housed within system 500 configured as a head-mounted device. In some examples, control circuitries 510 can be a standalone console device communicatively coupled with other components of system 500. In the example shown in FIG. 5, control circuitries 510 include an application store 545, a tracking module 550, and an engine 555.

The application store 545 stores one or more applications for execution by the control circuitries 510. An application is a group of instructions that, when executed by a processor, generates content for presentation to the user. Examples of applications include: gaming applications, conferencing applications, video playback applications, or other suitable applications.

Tracking module 550 calibrates system 500 using one or more calibration parameters and may adjust one or more calibration parameters to reduce error in determination of the position of the near-eye display 100.

Tracking module 550 tracks movements of near-eye display 100 using slow calibration information from the imaging device 535. Tracking module 550 also determines positions of a reference point of near-eye display 100 using position information from the fast calibration information.

Engine 555 executes applications within system 500 and receives position information, acceleration information, velocity information, and/or predicted future positions of near-eye display 100 from tracking module 550. In some embodiments, information received by engine 555 may be used for producing a signal (e.g., display instructions) to waveguide display assembly 210 that determines a type of content presented to the user. For example, to provide an interactive experience, engine 555 may determine the content to be presented to the user based on a location of the user (e.g., provided by tracking module 550), or a gaze point of the user (e.g., based on image data provided by imaging device 535), a distance between an object and user (e.g., based on image data provided by imaging device 535).

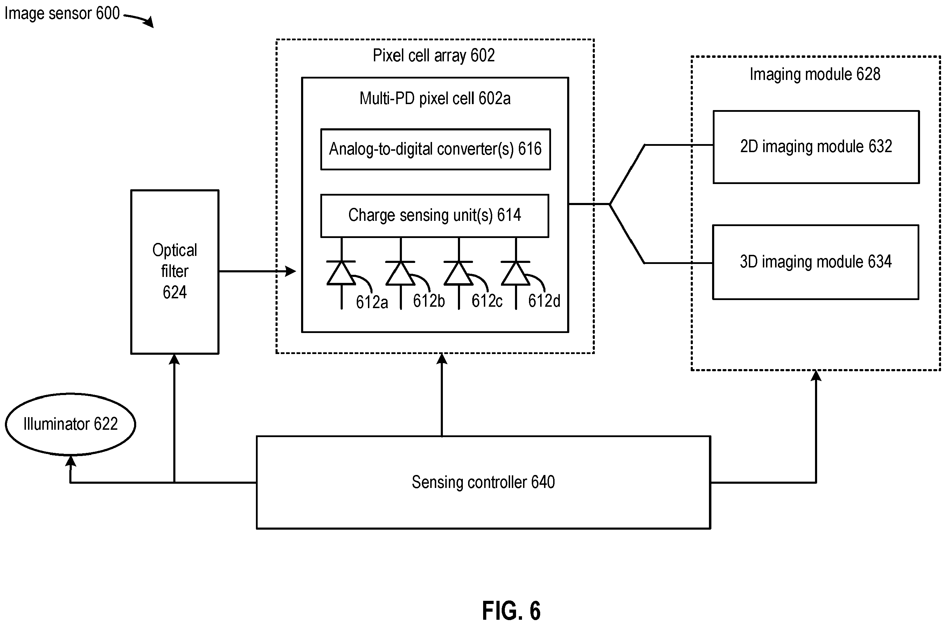

FIG. 6 illustrates an example of an image sensor 600 that can include a dual pixel array. Image sensor 600 can be part of near-eye display 100 and can provide 2D and 3D image data to control circuitries 510 of FIG. 5 to control the display content of near-eye display 100. As shown in FIG. 6, image sensor 600 may include an array of pixel cells 602 including pixel cell 602a. Although FIG. 6 illustrates only a single pixel cell 602a, it is understood that an actual pixel cell array 602 can include may pixel cells. Pixel cell array 602 may be a dual pixel array wherein the pixel cells are arranged according to an arrangement. In the arrangement, the pixel cell array 602 includes both color and monochrome photodiodes, such that each color photodiode has as least one associated monochrome photodiode located on the array.

Pixel cell 602a can include a plurality of photodiodes 612 including, for example, photodiodes 612a, 612b, 612c, and 612d, one or more charge sensing units 614, and one or more analog-to-digital converters 616. The plurality of photodiodes 612 can convert different components of incident light to charge. For example, photodiode 612a-612c can correspond to different visible light channels, in which photodiode 612a can convert a visible blue component (e.g., a wavelength range of 450 - 490 nanometers (nm)) to charge. Photodiode 612b can convert a visible green component (e.g., a wavelength range of 520 - 560 nm) to charge. Photodiode 612c can convert a visible red component (e.g., a wavelength range of 635 - 700 nm) to charge. Moreover, photodiode 612d can convert an infra-red component (e.g., 700 - 1000 nm) to charge. Each of the one or more charge sensing units 614 can include a charge storage device and a buffer to convert the charge generated by photodiodes 612a-612d to voltages, which can be quantized by one or more ADCs 616 into digital values. The digital values generated from photodiodes 612a-612c can represent the different visible light components of a pixel, and each can be used for 2D sensing in a particular visible light channel. Moreover, the digital value generated from photodiode 612d can represent the infra-red light component of the same pixel and can be used for 3D sensing. Although FIG. 6 shows that pixel cell 602a includes four photodiodes, it is understood that the pixel cell can include a different number of photodiodes (e.g., two, three, etc.).

In some examples, image sensor 600 may also include an illuminator 622, an optical filter 624, an imaging module 628, and a sensing controller 630. Illuminator 622 may be an infra-red illuminator, such as a laser, a light emitting diode (LED), etc., that can project infra-red light for 3D sensing. The projected light may include, for example, structured light, light pulses, etc. Optical filter 624 may include an array of filter elements overlaid on the plurality of photodiodes 612a-612d of each pixel cell including pixel cell 606a. Each filter element can set a wavelength range of incident light received by each photodiode of pixel cell 606a. For example, a blue chromatic filter over photodiode 612a may transmit the visible blue light component while blocking other components, a green chromatic filter over photodiode 612b may transmit the visible green light component, a red chromatic filter over photodiode 612c may transmit the visible red light component, whereas a filter element over photodiode 612d may transmit the infra-red light component.

Image sensor 600 further includes an imaging module 628. Imaging module 628 may further include a 2D imaging module 632 to perform 2D imaging operations and a 3D imaging module 634 to perform 3D imaging operations. The operations can be based on digital values provided by ADCs 616. For example, based on the digital values from each of photodiodes 612a-612c , 2D imaging module 632 can generate an array of pixel values representing an intensity of an incident light component for each visible color channel, and generate an image frame for each visible color channel. Moreover, 3D imaging module 634 can generate a 3D image based on the digital values from photodiode 612d. In some examples, based on the digital values, 3D imaging module 634 can detect a pattern of structured light reflected by a surface of an object, and compare the detected pattern with the pattern of structured light projected by illuminator 622 to determine the depths of different points of the surface with respect to the pixel cells array. For detection of the pattern of reflected light, 3D imaging module 634 can generate pixel values based on intensities of infra-red light received at the pixel cells. As another example, 3D imaging module 634 can generate pixel values based on time-of-flight of the infra-red light transmitted by illuminator 622 and reflected by the object. Image sensor 600 further includes a sensing controller 640 to control different components of image sensor 600 to perform 2D and 3D imaging of an object.

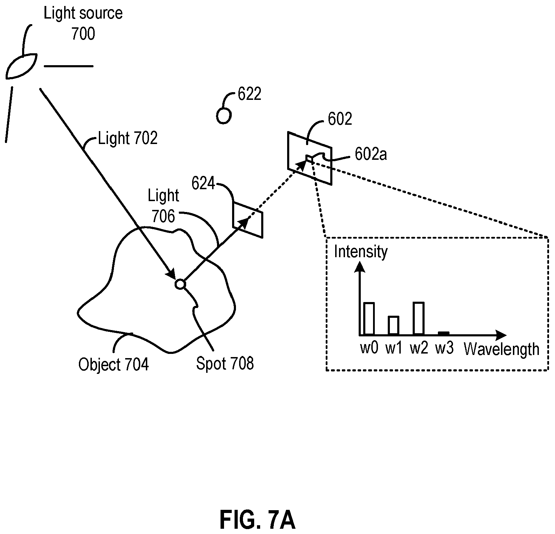

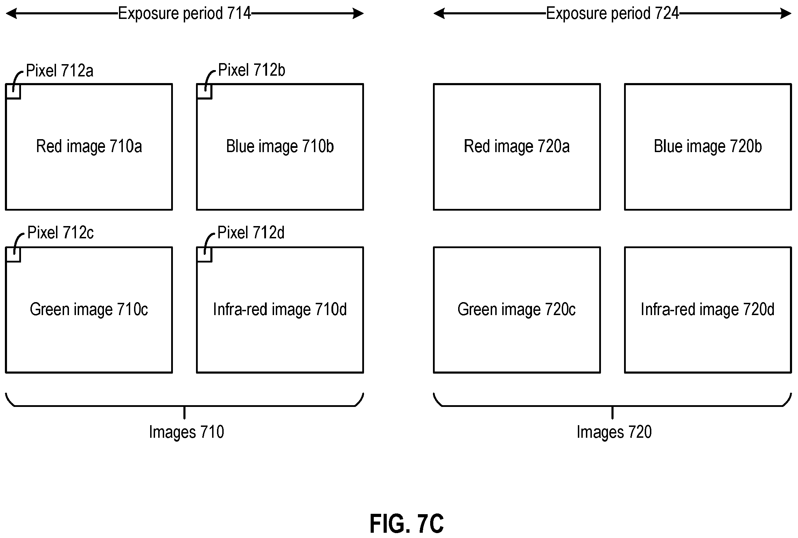

Reference is now made to FIG. 7A - FIG. 7C, which illustrate examples of operations of image sensor 600 for 2D and 3D imaging. FIG. 7A illustrates an example of operations for 2D imaging. For 2D imaging, pixel cells array 602 can detect visible light in the environment including visible light reflected off an object. For example, referring to FIG. 7A, visible light source 700 (e.g., a light bulb, the sun, or other sources of ambient visible light) can project visible light 702 onto an object 704. Visible light 706 can be reflected off a spot 708 of object 704. Visible light 706 can also include the ambient infra-red light component. Visible light 706 can be filtered by optical filter array 624 to pass different components of visible light 706 of wavelength ranges w0, w1, w2, and w3 to, respectively, photodiodes 612a, 612b, 612c, and 612d of pixel cell 602a. Wavelength ranges w0, w1, w2, and w3 an correspond to, respectively, blue, green, red, and infra-red. As shown in FIG. 7A, as the infra-red illuminator 622 is not turned on, the intensity of infra-red component (w3) is contributed by the ambient infra-red light and can be very low. Moreover, different visible components of visible light 706 can also have different intensities. Charge sensing units 614 can convert the charge generated by the photodiodes to voltages, which can be quantized by ADCs 616 into digital values representing the red, blue, and green components of a pixel representing spot 708. Referring to FIG. 7C, after the digital values are generated, sensing controller 640 can control 2D imaging module 632 to generate, based on the digital values, sets of images including a set of images 710, which includes a red image frame 710a, a blue image frame 710b, and a green image frame 710c each representing one of red, blue, or green color image of a scene captured with the same exposure period 714. Each pixel from the red image (e.g., pixel 712a), from the blue image (e.g., pixel 712b), and from the green image (e.g., pixel 712c) can represent visible components of light from the same spot (e.g., spot 708) of a scene. A different set of images 720 can be generated by 2D imaging module 632 in a subsequent exposure period 724. Each of red image 710a, blue image 710b, and green image 710c can represent the scene in a specific color channel and can be provided to an application to, for example, extract image features from the specific color channel. As each image represents the same scene and each corresponding pixel of the images represent light from the same spot of the scene, the correspondence of images between different color channels can be improved.

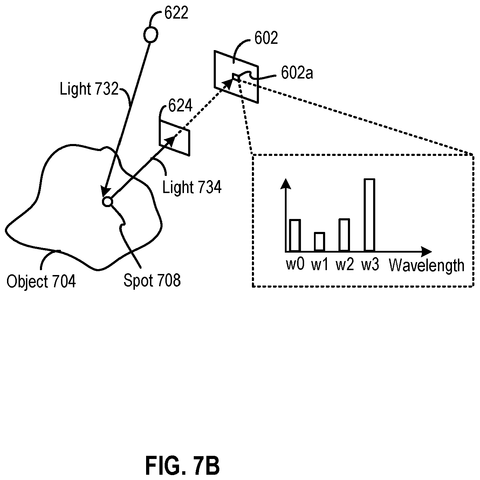

Furthermore, image sensor 600 can also perform 3D imaging of object 704. Referring to FIG. 7B, sensing controller 610 can control illuminator 622 to project infra-red light 732, which can include a light pulse, structured light, etc., onto object 704. Infra-red light 732 can have a wavelength range of 700 nanometers (nm) to 1 millimeter (mm). Infra-red light 734 can reflect off spot 708 of object 704 and can propagate towards pixel cells array 602 and pass through optical filter 624, which can provide the infra-red component (of wavelength range w3) to photodiode 612d to convert to charge. Charge sensing units 614 can convert the charge to a voltage, which can be quantized by ADCs 616 into digital values. Referring to FIG. 7C, after the digital values are generated, sensing controller 640 can control 3D imaging module 634 to generate, based on the digital values, an infra-red image 710d of the scene as part of images 710 captured within exposure period 714. As infra-red image 710d can represent the same scene in the infra-red channel and a pixel of infra-red image 710d (e.g., pixel 712d) represents light from the same spot of the scene as other corresponding pixels (pixels 712a-712c) in other images within images 710, the correspondence between 2D and 3D imaging can be improved as well.

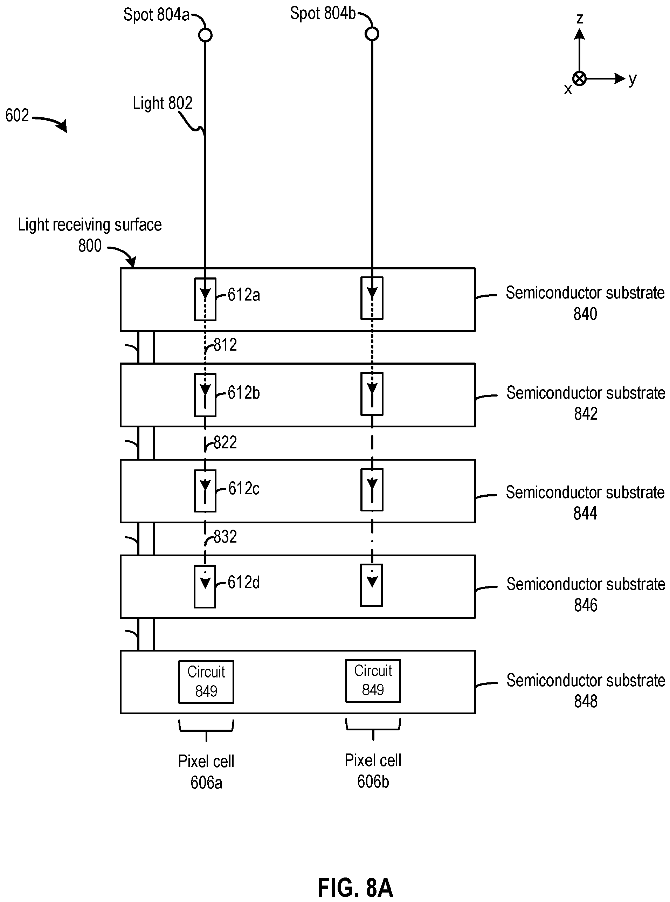

FIG. 8A - FIG. 8E illustrate examples of arrangements of photodiodes 612 in an image sensor, such as within a pixel cell or between different pixel cells. As shown in FIG. 8A, the photodiodes 612a-612d in a pixel cell 602a can form a stack along an axis that is perpendicular to a light receiving surface 800 through which pixel cell 602a receives incident light 802 from a spot 804a. For example, the photodiodes 612a-612d can form a stack along a vertical axis (e.g., the z-axis) when the light receiving surface 800 is parallel with the x and y axes. Each photodiode can have a different distance from light receiving surface 800, and the distance can set the component of incident light 802 being absorbed and converted to charge by each photodiode. For example, photodiode 612a is closest to light receiving surface 800 and can absorb and convert the blue component to charge, which is of the shortest wavelength range among the other components. Light 812 includes the remaining components of light 802 (e.g., green, red, and infra-red) and can propagate to photodiode 612b, which can absorb and convert the green component. Light 822 includes the remaining components of light 812 (e.g., red and infra-red) and can propagate to photodiode 612c, which can absorb and convert the red component. The remaining infra-red component 832 can propagate to photodiode 612d to be converted to charge.

Each the photodiodes 612a, 612b, 612c, and 612d can be in a separate semiconductor substrate, which can be stacked to form image sensor 600. For example, photodiode 612a can be in a semiconductor substrate 840, photodiode 612b can be in a semiconductor substrate 842, photodiode 612c can be in a semiconductor substrate 844, whereas photodiode 612d can be in a semiconductor substrate 846. Each of substrates 840-846 can include a charge sensing unit, such as charge sensing units 614. Substrates 840-846 can form a sensor layer. Each semiconductor substrate can include other photodiodes of other pixel cells, such as pixel cells 602b to receive light from spot 804b. Image sensor 600 can include another semiconductor substrate 848 which can include pixel cell processing circuits 849 which can include, for example, ADCs 616, imaging module 628, sensing controller 640, etc. In some examples, charge sensing units 614 can be in semiconductor substrate 848. Semiconductor substrate 848 can form an application specific integrated circuit (ASIC) layer. Each semiconductor substrate can be connected to a metal interconnect, such as metal interconnects 850, 852, 854, and 856 to transfer the charge generated at each photodiode to processing circuit 849.

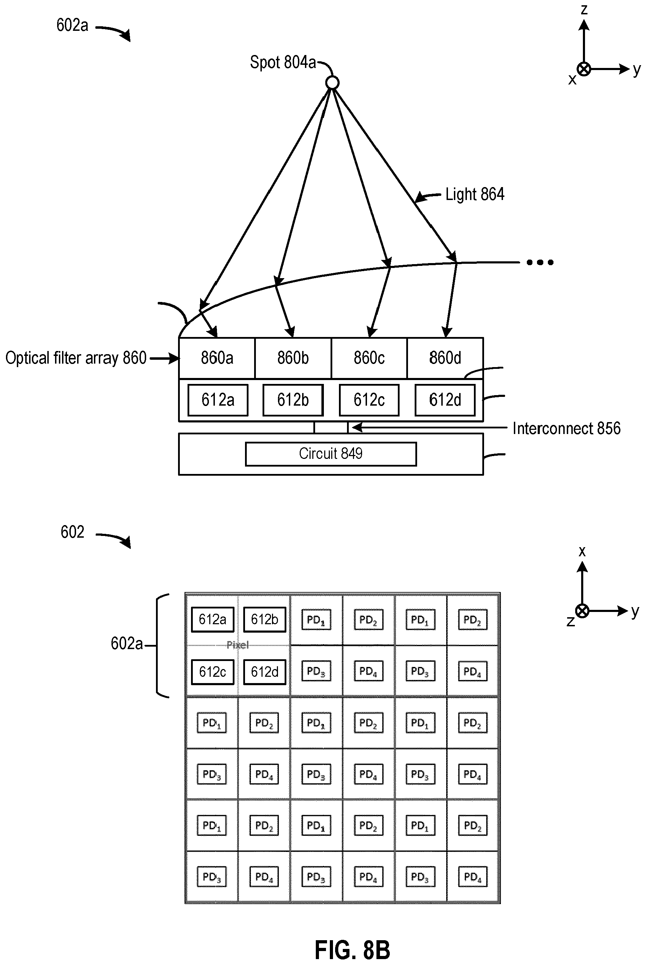

FIG. 8B - FIG. 8D illustrate other example arrangements of photodiodes 612 within a pixel cell. As shown in FIG. 8B - FIG. 8D, the plurality of photodiodes 612 can be arranged laterally, parallel with light receiving surface 800. The top graph of FIG. 8B illustrates a side view of an example of pixel cell 602a, whereas the bottom graph of FIG. 8B illustrates a top view of pixel array 602 including pixel cell 602a. The top graph and the bottom graph may illustrate two different example arrangements of photodiodes. For example, in the top graph four pixel cells 612a, 612b, 612c, and 612d can be arranged in a 4x1 pattern, while the bottom graph the four pixel cells are arranged in a 2x2 pattern.

As shown in FIG. 8B, with light receiving surface 800 being parallel with the x and y axes, photodiodes 612a, 612b, 612c, and 612d can be arranged adjacent to each other also along the x and y axes in semiconductor substrate 840. Pixel cell 602a further includes an optical filter array 860 overlaid on the photodiodes. Optical filter array 860 can be part of optical filter 624. Optical filter array 860 can include a filter element overlaid on each of photodiodes 612a, 612b, 612c, and 612d to set a wavelength range of incident light component received by the respective photodiode. For example, filter element 860a is overlaid on photodiode 612a and can allow only visible blue light to enter photodiode 612a. Moreover, filter element 860b is overlaid on photodiode 612b and can allow only visible green light to enter photodiode 612b. Further, filter element 860c is overlaid on photodiode 612c and can allow only visible red light to enter photodiode 612c. Filter element 860d is overlaid on photodiode 612d and can allow only infra-red light to enter photodiode 612d.

Pixel cell 602a further includes one or more microlens 862 which can project light 864 from a spot of a scene (e.g., spot 804a) via optical tiler array 860 to different lateral locations of light receiving surface 800, which allows each photodiode to become a sub-pixel of pixel cell 602a and to receive components of light from the same spot corresponding to a pixel. In some examples, a single microlens 862 can be overlaid on multiple pixels as shown in FIG. 8B. In some examples, a single microlens 862 can be overlaid on a pixel, and each pixel can have a single microlens.

Pixel cell 602a can also include semiconductor substrate 848 which can include circuit 849 (e.g., charge sensing units 614, ADCs 616, etc.) to generate digital values from the charge generated by the photodiodes. Semiconductor substrates 840 and 848 can form a stack and can be connected with interconnect 856. In FIG. 8B, semiconductor substrate 840 can form a sensor layer, whereas semiconductor substrate 848 can form an ASIC layer.

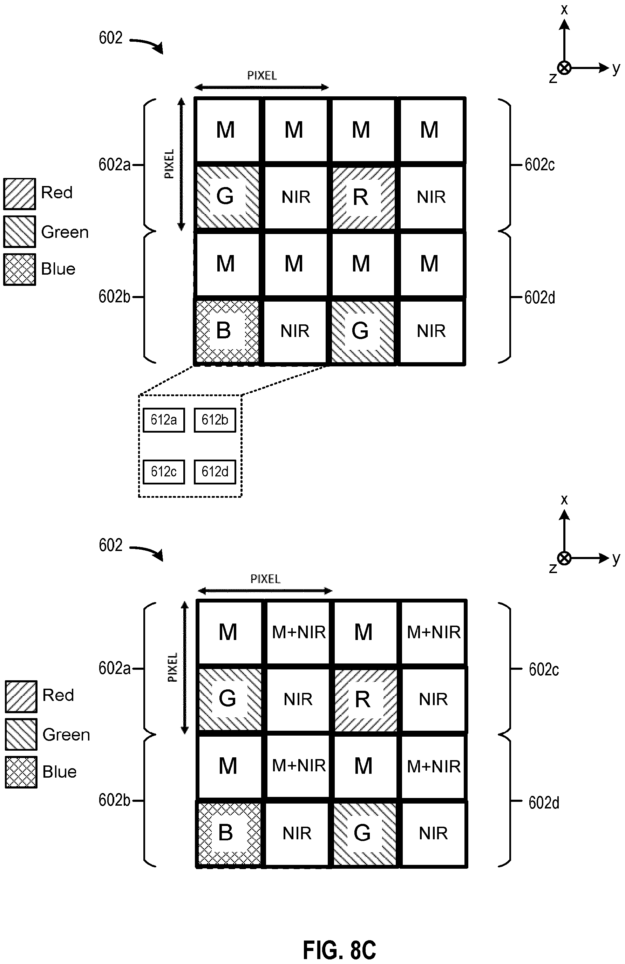

The arrangements of FIG. 8B, in which the photodiodes are arranged laterally and an optical filter array is used to control the light components received by the photodiodes, can offer numerous advantages. For example, the number of stacks and the number of semiconductor substrates can be reduced, which not only reduce the vertical height but also the interconnects among the semiconductor substrates. Moreover, relying on filter elements rather than the propagation distance of light to set the wavelength ranges of the components absorbed by each photodiode can offer flexibilities in selecting the wavelength ranges. As shown in top graph of FIG. 8C, pixel cells array 602 can include different optical filter arrays 860 for different pixel cells. For example, each pixel cell of pixel cells array 602 can have a optical filter array that provides monochrome channel of a wavelength range of 380 - 740 nm (labelled with "M") for photodiodes 612a and 612b, and an infra-red channel of a wavelength range of 700 - 1000 nm (labelled with "NIR") for photodiode 612d. But the optical filter arrays may also provide a different visible color channel for the different pixel cells. For example, the optical filter arrays 860 for pixel cells array 602a, 602b, 602c, and 602d may provide, respectively, a visible green channel (labelled with "G"), a visible red channel (labelled with "R"), a visible blue channel (labelled with "B"), and a visible green channel for photodiode 612c of the pixel cells arrays. As another example, as shown in the bottom graph of FIG. 8C, each optical filter array 860 can provide a monochrome and infra-red channel (labelled "M+NIR") which spans a wavelength range of 380 - 1000 nm for photodiode 612b of each pixel cells array.

Heterogenous arrangements of optical filter arrays as depicted in FIG. 8C can support readout strategies to support various types of images. For example, the monochrome channel readout circuitry could be configured to selectively read out all monochrome photodiodes or only photodiodes that include an infra-red filter. In another example, where each sensor pixel includes three monochrome photodiodes for every one color photodiode, as depicted in FIG. 8C, extracted monochrome images may have three times the resolution of the associated color image. Alternatively, the pixel value for the three monochrome photodiodes for each sensor pixel could be combined to produce an image with the same resolution as the associated color image. This could also be accomplished with an alternative arrangement (not shown), in which each sensor pixel can have three color photodiodes for every one monochrome photodiode, thus resulting in a color image with the same resolution as the associated monochrome image.

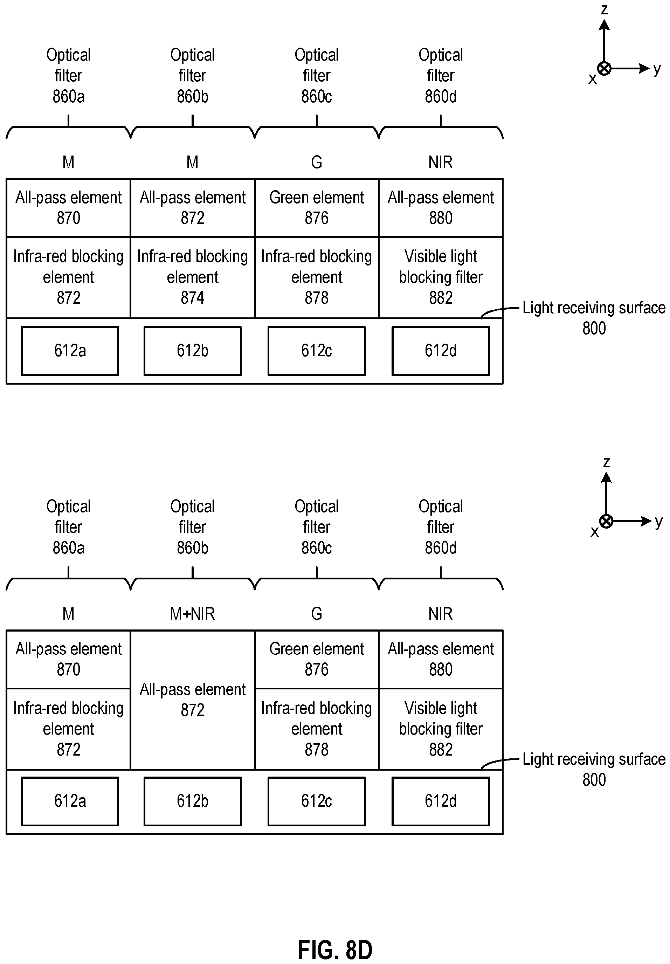

FIG. 8D illustrates examples of optical filter array 860 to provide the example channels shown in FIG. 8C. As shown in FIG. 8D, optical filter array 860 can include a stack of optical filters to select a wavelength range of light received by each photodiode within a pixel cell array. For example, referring to the top graph of FIG. 8D, optical filter 860a can include an all-pass element 870 (e.g., a transparent glass that passes both visible light and infra-red light) and an infra-red blocking element 872 forming a stack to provide a monochrome channel for photodiode 612a. Optical filter 860b can also include an all-pass element 874 and an infra-red blocking element 876 to also provide a monochrome channel for photodiode 612b. Further, optical filter 860c can include a green-pass element 876 which passes green visible light (but reject other visible light component), and an infra-red blocking element 878, to provide a green channel for photodiode 612c. Lastly, optical filter 860d can include an all-pass element 880 and a visible light blocking filter 882 (which can block out visible light but allows infra-red light to go through) to provide an infra-red channel for photodiode 612d. In another example, as shown in the bottom graph of FIG. 8D, optical filter 860b can include only all-pass element 872 to provide a monochrome and infra-red channel for photodiode 612b.

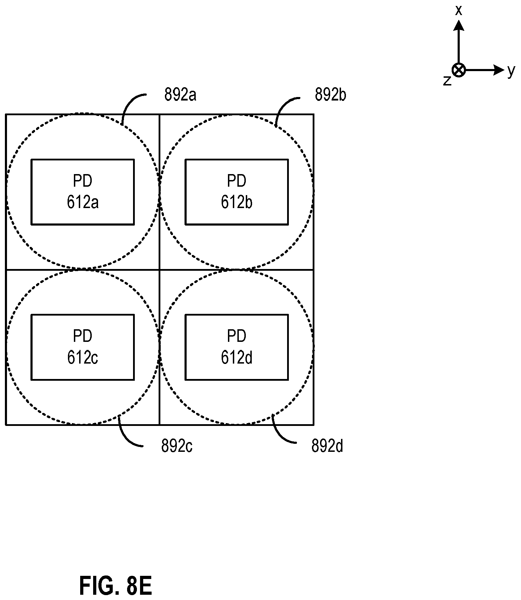

FIG. 8E illustrates another example optical configurations of photodiodes 612 and their associated microlenses. As shown in FIG. 8E, instead of overlaying a microlens 862 over a plurality of photodiodes, as shown in FIG. 8B, a plurality of microlenses 892 can be overlaid over the plurality of photodiodes 612a-612d, which are arranged in a 2x2 format. For example, microlens 892a can be overlaid over photodiode 612a, microlens 892b can be overlaid over photodiode 612b, microlens 892c can be overlaid over photodiode 612c, whereas microlens 892d can be overlaid over photodiode 612d. With such arrangements, each photodiode can correspond to a pixel, which can shrink the required footprint of pixel cell array to achieve a target resolution.

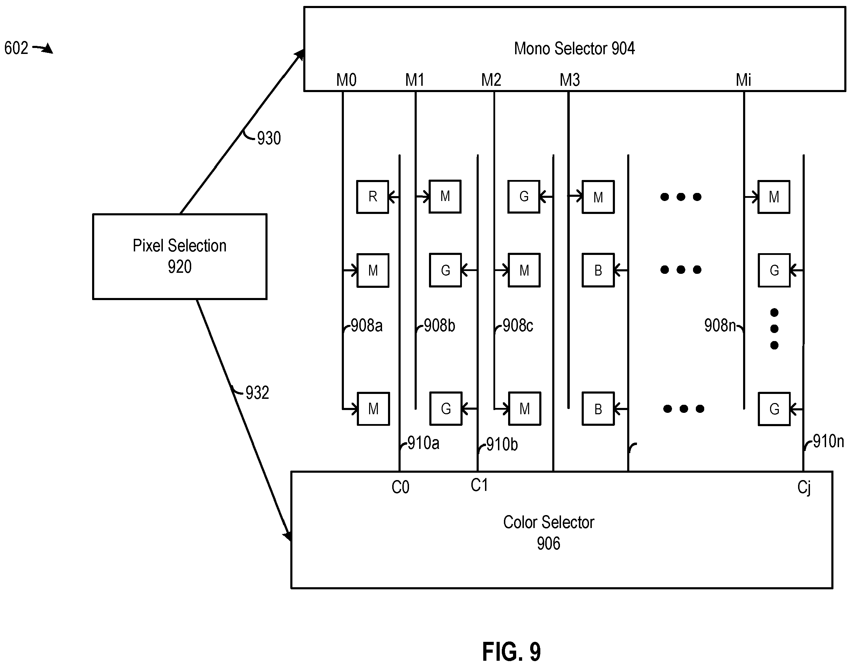

FIG. 9 illustrates an example of pixel array 602 for providing a dual pixel structure. The example pixel array 602 includes components that can be used to affect the simultaneous readout of monochrome or color channels located on the same pixel array. Example pixel array 602 depicts one example arrangement of pixels, but other arrangements are possible. In the dual pixel array, each color pixel has one or more associated monochrome pixels located on the array. The pixel array 602 includes one or more controllers that may be used to selectively read out all or a portion of the monochrome channel or all or a portion of one or more color channels.

As shown in FIG. 9, pixel cell array 602 may include a monochrome selection controller 904, a color selection controller 906, and a pixel selection controller 920. Monochrome selection controller 904 is connected with monochrome-select lines 908 (e.g., 908a, 908b, 908c, ... 908n), whereas color selection controller 906 is connected with color-select lines 910 (e.g., 910a, 910b, ... 910n). Each box labelled M, R, G, or B represents a photodiode. Each monochrome photodiode is connected to one of monochrome-select lines 908. Each color pixel is connected to a color-select line 910. Monochrome-select lines 908 and color-select lines 910 are coupled to an output data bus to output pixel data (not shown in FIG. 9). In some examples, individual colors may have a dedicated color selection controller. For instance, a certain embodiment may include a red, green, and blue color selection controller that are only connected to photodiodes of the associated color.

Each photodiode is individually addressable by monochrome-enable signals 930 on monochrome-select lines 908 provided by monochrome selection controller 904, and color-enable signals 932 on color-select lines 910 provided by color selection controller 906. Monochrome-enable signals 930 and color-enable signals 932 can be generated based on information received from sensing controller 640. For use with a global shutter, for example, the monochrome channel can be read out by selecting all monochrome pixels via the monochrome-select lines 908. For use with a rolling shutter, the monochrome selection controller 904 can be configured to select one column of monochrome sensors at time, in succession, to affect the rolling shutter. Similar configurations can be made for each color channel.

Although FIG. 9 depicts the monochrome-select lines 908 and color-select lines 910 operating on columns, this is only drawn for illustrative purposes and is not meant to be limiting. For example, either of the monochrome-select lines 908 or color-select lines 910 could be configured to operate on row of photodiodes, to connect only to individual photodiodes, or to other subsets of photodiodes. In some examples, the monochrome and color channels can be configured to use different shutter operations. For example, the monochrome camera may use a global shutter operation while the color camera uses a rolling shutter operation for substantially simultaneous image capture.

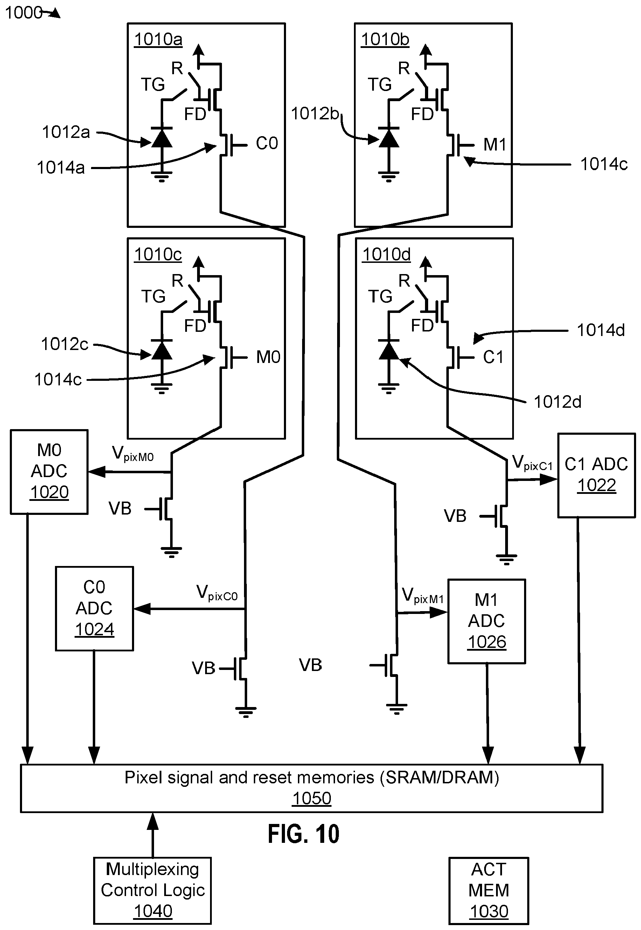

FIG. 10 illustrates an example pixel array 1000, which has four pixels 1010a-d arranged in a 2x2 grid. The example pixel array 1000 includes only two monochrome pixels and two color pixels for illustrative purposes. However, the dual pixel array may have any suitable dimensions. Each pixel 1010a-d includes a light-sensing element 1012a-d, which in this example is a photodiode. The light-sensing elements 1012a-d are each connected to a charge storage device, which in this example is a floating diffusion ("FD") region. During an exposure period, the light-sensing elements 1012a-d receive incoming light and generate electric charge, which is stored on the corresponding charge storage device as a voltage.

Each pixel also includes a select switch. Color pixels 1010a, 1010d includes color-select switches 1014a and 1014d, respectively. Monochrome pixels 1010b and 1010c include monochrome-select switches 1014b and 1014c, respectively. The color- and monochrome-select switches 1014a-d are connected to the color-enable lines 910 and monochrome-enable lines 908 as shown in FIG. 9. In this example, the four pixels are connected to monochrome-enable lines M0 and M1, color-enable line C0, and color-enable line C1. resulting in different pixels transferring voltage to the ADCs 1020, 1022, 1024, 1026 depending on which particular lines are enabled. In some examples, individual colors may have dedicated color select lines. For instance, a certain embodiment may include red, green, and blue color select lines that are only connected to photodiodes of the associated color.

In addition to the pixels 1010a-d, the example pixel array 1000 depicts ADCs 1020, 1022, 1024, 1026 connected to each pixel, an activation memory 1030, and a multiplexing control 1040 logic. The ADCs 1020, 1022, 1024, 1026 are connected to each of the pixels 1010a-d to receive a voltage, Vₚᵢₓ, from each pixel selected by either a monochrome or color select switch 1014a-d closed in concert with the respective VBs. It converts the voltage to a pixel value, which is then stored in memory 1050. The multiplexing control logic 1040 ensures the monochrome and color channels can be read out simultaneously, sequentially, or according to any desired temporal sequence using shared circuitry. Further, configuration information that includes the pixel arrangement to select specific color channels is stored in the activation memory 1030. ADCs in some embodiments may be configured differently. For example, all monochrome photodiodes could share one or more ADCs while each set of color photodiodes (red, green, and blue) could each share one or more ADCs.

After the ADCs 1020, 1022, 1024, 1026 have converted a pixel's value, the input voltage is reset by opening the respective pixel's monochrome- or color-select switches. The monochrome- or color-enable lines for the next pixel(s) or channels to be read may then be enabled. For instance, the monochrome channel may be read first, followed by the color channels in close succession. In another example, the monochrome channel and the color channels may be read out simultaneously.

In some examples, the monochrome and color sensors may operate in correlated double sampling ("CDS") mode. In CDS mode, immediately following reset of the input voltage, another set of channel readouts is performed. Due to inherent background noise due to cosmic rays, electrical artifacts, thermal effects, quantum effects, etc. the post-reset pixel values are likely non-zero. Following readout of the post-reset pixel values, monochrome and color images can be captured using the methods described above. During post-processing, the post-reset pixel values may be subtracted from the pixel values captured during integration to remove the approximate noise level. Because background noise varies based on environmental conditions, capturing the post-reset pixel values immediately before exposure can lead to more accurate removal of background noise.

Selective control of the monochrome- and color-enable lines can provide the necessary configuration for shutter mode. For example, both the monochrome and color camera may be operated in global shutter mode for substantially simultaneous integration periods using parallel circuitry as described above. Alternatively, the monochrome camera may use a global shutter operation while the color camera uses a rolling shutter operation. Rolling shutter operations can be vulnerable to the creation of undesirable image artifacts. The MR display, which utilizes the color camera, may be only minimally affected by such artifacts, resulting in a negligible degradation of the user experience ("UX"). On the other hand, the monochrome camera, utilized in computer vision tasks, may experience significant adverse effects from artifacts due to the rolling shutter. Therefore the global shutter may be preferred for monochrome camera operations.

Further, areal density may be improved by forming portions of the pixel on one layer of a substrate and other portions on a second layer. For example, a first layer of the substrate may include the pixels, while a second layer may include the ADCs 1020, 1022, 1024, 1026, activation memory 1030, multiplexing control logic 1040, and the memory 1050. By stacking different components in different substrate layers, pixel density may be increased.

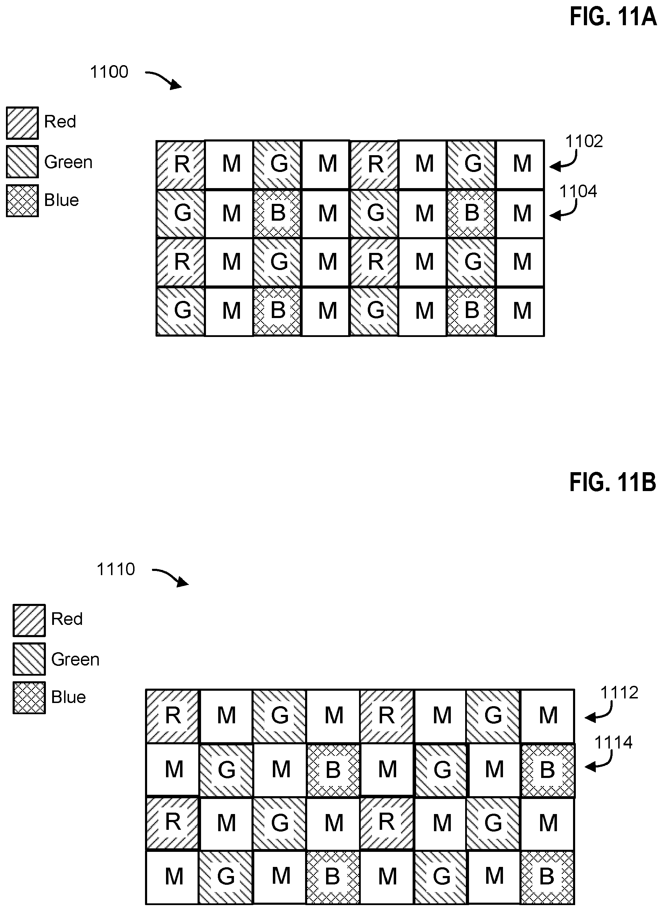

FIGS. 11A-B illustrate two example arrangements of pixels in a dual pixel array. FIG. 11A shows an example pixel array arrangement 1100. The arrangement 1100 includes two repeating rows including monochrome, red, green, and blue pixels. The first row 1102 includes a red pixel, then a monochrome pixel, then a green pixel, then another monochrome pixel. The same sequence repeats in the first row 1102 until the edge of the pixel array is reached. The second row 1104 includes a green pixel, then a monochrome pixel, then a blue pixel, then another monochrome pixel. The same sequence repeats in the second row 1104 until the edge of the pixel array is reached. The sequence of pixels of the first row 1102 and the second row 1104 then repeat, alternating rows until the bottom edge of the pixel array is reached.

The repeating group of colors in arrangement 1100 may correspond to the colors in a color filter array. The color filter array can be used to combine the color channels corresponding two or more colors to produce a composite color image. For example, a Bayer filter can combine one red channel, two green channels, and one blue channel to produce a composite color image.

FIG. 11B shows an example pixel array arrangement 1110. The arrangement 1110 includes two repeating rows including monochrome, red, green, and blue pixels. The first row 1112 includes a red pixel, then a monochrome pixel, then a green pixel, then another monochrome pixel. The same sequence repeats in the first row 1112 until the edge of the pixel array is reached. The second row 1114 includes a monochrome pixel, then a green pixel, then a monochrome pixel, then a blue pixel. The same sequence repeats in the second row 1114 until the edge of the pixel array is reached. The sequence of pixels of the first row 1112 and the second row 1114 then repeat, alternating rows until the bottom edge of the pixel array is reached. In some examples, the arrangement 1110 is preferable to minimize crosstalk between adjacent color or monochrome pixel.

It will be appreciated by one skilled in the art that the arrangements 1100 and 1110 in FIG. 11 are just example arrangements. Any arrangement of color and monochrome pixels such that each color pixel has at least one corresponding monochrome pixel located on the pixel array is possible. For example, the monochrome and color pixels could be distributed randomly, according to another color filter array pattern, or using other color filters besides RGB (e.g., cyan, yellow, and magenta). For instance, while the arrangements 1100, 1110 shown in these examples provide RGGB color channels, any suitable combination of filters may be used according to different examples. For example, one of the green filters may be replaced by an IR filter or a UV filter. In some examples, entirely different sets of filters may be employed, e.g., white, yellow, IR, UV, etc. Thus, the number of pixels, the corresponding filters, and the pixel's arrangement within the dual pixel array may be in any suitable configuration for a particular application.

As discussed in FIGS. 8B and 8E, some examples include microlenses over individual photodiodes as well as over a plurality of photodiodes. In some other examples, the microlens configuration can be adjusted according to the arrangement. For example, in arrangement 1100, coverage of the dual pixel array using microlenses could be affected with a microlens over each photodiode, over pairs of photodiodes (1x2), 2x2 groups of photodiodes, 2x4 groups of photodiodes, and so on. For instance, in arrangement 1100, each adjacent pair of monochrome and color photodiodes may have a 1x2 microlens. Grouping multiple photodiodes with the same microlens may be advantageous because it can result in reduced calibration and thermal correction requirements.

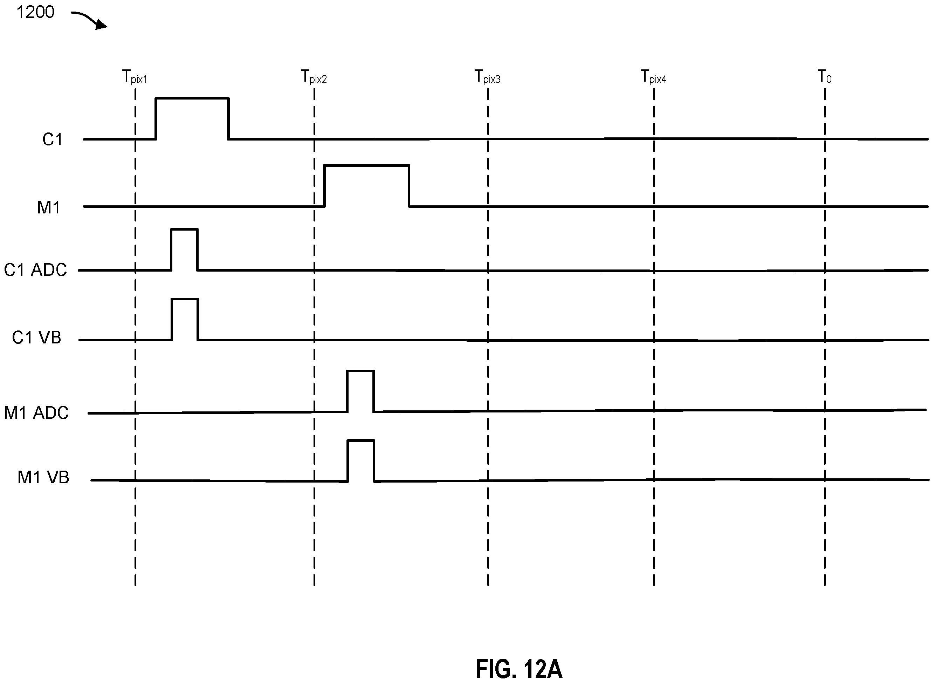

FIGS. 12A-B show timing diagrams 1200, 1210 for the example pixel array 1000 shown in FIG. 10 to capture the color channel and the monochrome channel, sequentially and simultaneously. Such a technique, in combination with the remainder of the color channels, could be used to generate a full-color, full-resolution image if the pixel array is configured with a suitable filter arrangement such as the arrangements from FIG. 11. The timing diagram 1200 begins at Tₚᵢₓ₁, which occurs after the exposure period for the pixels has completed. At Tₚᵢₓ₁, C1 is asserted to close corresponding color-select switches. Thus, pixel 1010d's voltage is presented to C1 ADC 1022 as V_{pixC1}. Subsequently, the C1 ADC 1022 and VB are enabled and the C1 ADC 1022 converts the voltage to a pixel value, which is stored in memory 1050. Finally, C1 is de-asserted. At Tₚᵢₓ₂, M1 is asserted, which presents the voltage from pixel 1010b to the M1 ADC 1026 where it is converted to a pixel value according to the same process as for pixel 1010d. For a complete monochrome image, pixel 1010c could be converted simultaneously with pixel 1010b by asserting M0 and converting its respective voltages.

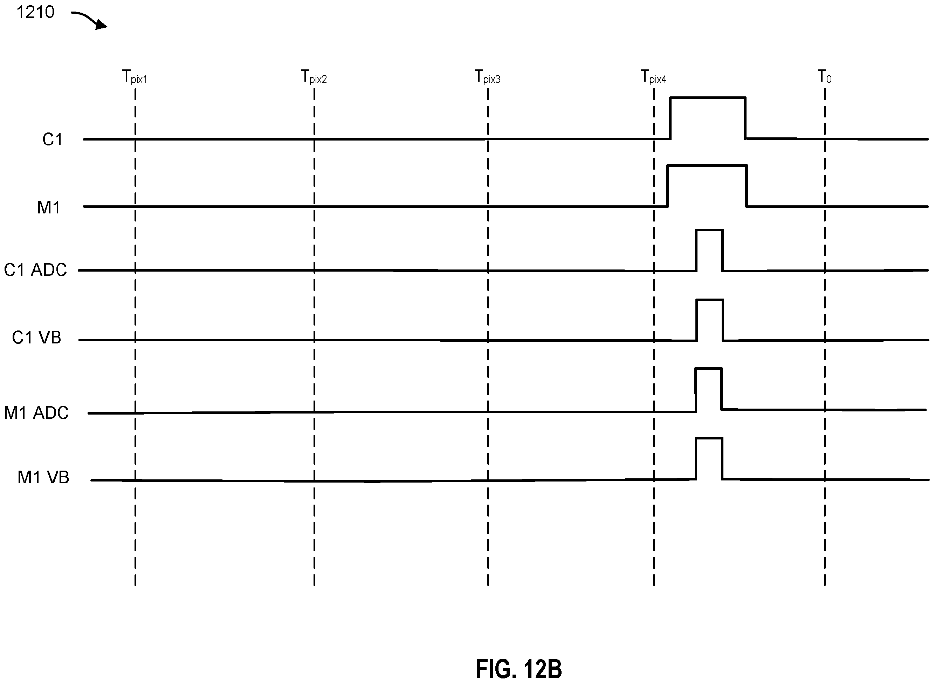

FIG. 12B depicts another timing diagram 1210 in which the color and monochrome channels are read out simultaneously instead of sequentially. Between Tₚᵢₓ₃ and Tₚᵢₓ₅, the color and monochrome channels are read out simultaneously, which may further reduce the need for calibrations or mappings to make the monochrome and color images correspond. Such a configuration provides full-color pixel values (including red, green, and blue color channels) for each pixel, thereby generating a full-resolution, full-color image. However, such comprehensive pixel information may not be needed in all examples.

In some embodiments, individual colors may have dedicated color select lines. For instance, a certain embodiment may include red, green, and blue color select lines that are only connected to photodiodes of the associated color. In those embodiments, similar timing diagrams to the ones depicted in FIGS. 12A-B could depict electronic control signals for selective control of the individual color channels.

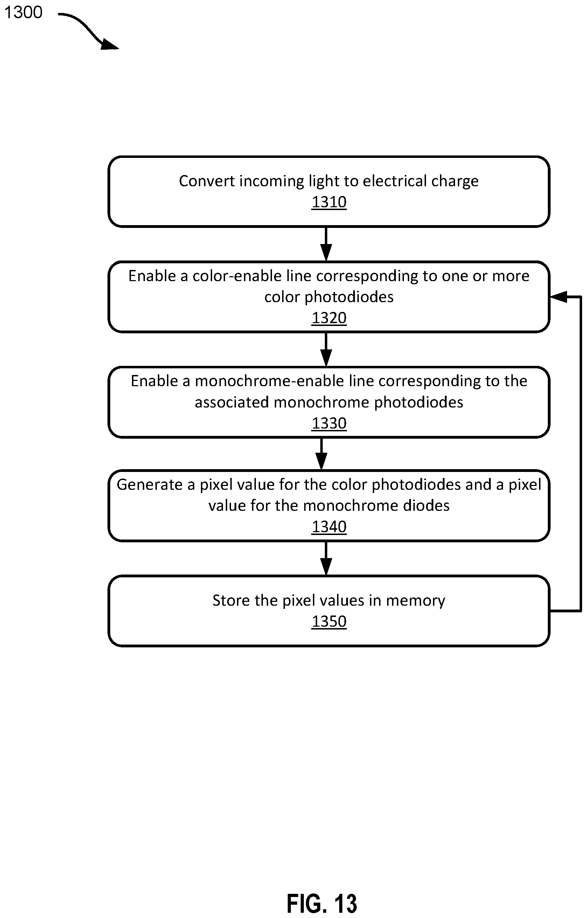

Referring now to FIG. 13, FIG. 13 shows a method 1300 for obtaining monochrome and color images from a dual pixel array. The example method 1300 will be described with respect to the pixel array 602 shown in FIGS. 6-10, and the pixel arrangements shown in FIGs. 11A-B; however, it should be appreciated that any suitable dual pixel array arrangement may be employed such that each color photodiode has an associated monochrome photodiode.

At block 1310, each photodiode in the dual pixel array 602 receives incoming light and converts it into electric charges during an exposure period. In this example, the electric charges are stored in a charge storage device included in a charge sensing unit 614, such as a floating diffusion. However, any suitable charge storage device may be employed. Further, in some examples, the electric charge may accumulate at the photodiode before later being connected to a discrete charge storage device, such as by one or more switches being closed to connect the photodiode to the charge storage device, such as illustrated in FIGs. 9-10.

At block 1320, the image sensor enables a color-enable line corresponding to one or more color photodiodes. As discussed above with respect to FIG. 9, the color-select lines 910 are connected to color photodiodes located in the dual pixel array 602. When a color-select line is enabled, e.g., G0, color-select switches in the corresponding pixels are closed. This completes the electrical pathway between the pixel and the color ADC 1022.

At block 1330, the image sensor enables a monochrome-enable line corresponding to the associated monochrome photodiodes. In dual pixel array 602, the color and monochrome photodiodes are selected and arranged such that each color photodiode has at least one monochrome photodiode elsewhere on the array. In some examples, the color and monochrome photodiodes may be adjacent. Similar to the color-select lines, each of the monochrome-select lines 908 is connected to monochrome photodiodes located in the dual pixel array 602. When a monochrome-select line is enabled, e.g., M0, monochrome-select switches in the corresponding pixels are closed. This completes the electrical pathway between the photodiode and the monochrome ADC 1020.

In certain examples, the process in block 1320 and 1330 can happen substantially simultaneously. For example, both the color and monochrome channels may be captured substantially simultaneously using a global shutter operation. Or, the monochrome channel may be captured using a global shutter operation and the color channel(s) may be captured using rolling shutter operations. Capture of the color and monochrome channels simultaneously using parallel circuitry may ensure that the resultant images can be simply mapped onto one another with a minimum of calibration and transformation.

At block 1340, the ADCs 1020, 1022, 1024, 1026 generate pixel values for each photodiode having a closed monochrome- or color-select switch. Pixel values may be determined for each photodiode individually to form a composite image when a global shutter is used. In some embodiments, the ADCs 1020, 1022, 1024, 1026 may be connected to rows or columns of photodiodes that can be read out individually to affect a rolling shutter mode.

At block 1350, the pixel values are stored in memory 1050.

Because the dual pixel array 602 has multiple channels, blocks 1320-1350 may be repeated for additional channels depending on whether channels are read out simultaneously or sequentially. For example, as discussed above with respect to FIG. 12A, between Tₚᵢₓ₁-Tₚᵢₓ₃, the color and monochrome channels are read out sequentially. Or, with respect to FIG. 12B, between Tₚᵢₓ₃-T₀, they are read out simultaneously. The selection of sequential or simultaneous readout of color and monochrome channels may be driven by power and efficiency considerations. In addition, in order to form a composite color image, at least three color channels may be required, so simultaneous readout of all channels may not be practicable. In some embodiments, readout of only a portion of a channel may be accomplished with selective use of the monochrome- or color-select switches. For example, in low light, only a subset of the monochrome photodiodes may be needed to obtain the resolution needed for 3D sensing.

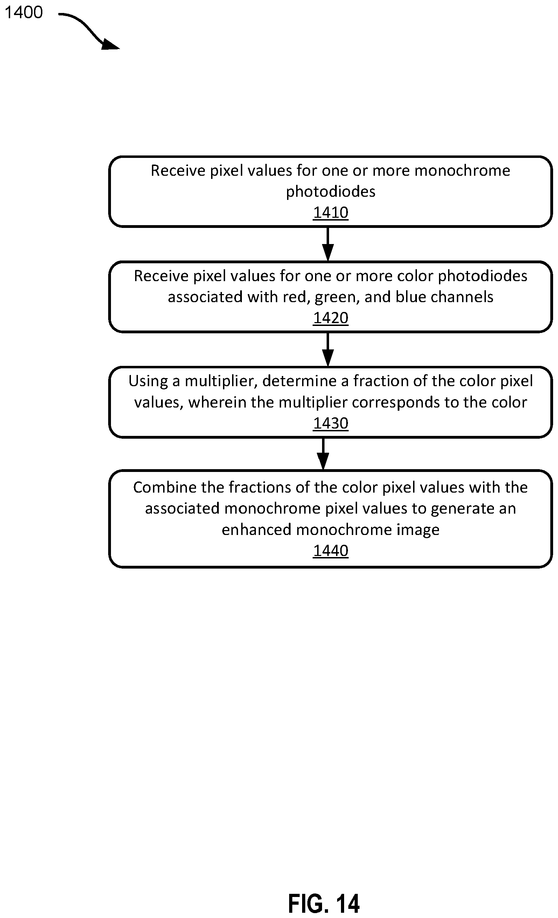

Referring now to FIG. 14, FIG. 14 shows a method 1400 for enhancing monochrome images information captured from the color channels. The example method 1400 will be described with respect to the pixel array 602 shown in FIGS. 6-10, and the pixel arrangements shown in FIGs. 11A-B; however, it should be appreciated that any suitable dual pixel array arrangement may be employed such that each color photodiode has an associated monochrome photodiode.

At block 1410, a computing device may receive pixel values from one or more monochrome photodiodes. Likewise, at block 1420, the computing device may receive pixel values associated with one or more color photodiodes. In particular, the computing device may receive pixel values for one or more red photodiodes, one or mode green photodiodes, and one or more blue photodiodes. As described above with respect to FIG. 13, following integration, the pixel values may be derived from stored charge and converted to pixel values using one or more ADCs 1020, 1022, 1024, 1026. The pixel values may be stored in a memory 1050. From memory 1050, the computing device may retrieve the pixel values and send them to the imaging module 628 for processing and enhancement.

At block 1430, the imaging module 628 may receive the pixel values in preparation for enhancing the monochrome image or for creating a synthetic monochrome image, when the monochrome image is unavailable. The imaging module 628 may use a multiplier (e.g., a conversion factor or ratio) to determine a fraction of the color channels to use to create the synthetic monochrome channel or enhance an existing monochrome image. In one example using red, green, and blue color channels, the multipliers are 0.271, 0.589, and 0.0073, respectively. The pixel values associated with each color channel are multiplied by the multiplier, resulting in a pixel value that is a fraction of the size of the original value.

At block 1440, the fractions of the pixel values of the color channels are combined with an existing monochrome image to produce an enhanced monochrome image. For example, in very low light, the monochrome signal may be too low to perform certain computer vision tasks. Combination with the color channels as described in method 1400 may provide sufficient monochrome signal to perform those tasks.

In some examples, wherein a starting monochrome image is unavailable, the fractions of the pixel values of the color channels are simply combined to produce a synthetic monochrome image. For example, in a wearable device with no monochrome camera and only a color camera, a monochrome image could be simulated using the process 1400.

The foregoing description of some examples has been presented only for the purpose of illustration and description and is not intended to be exhaustive or to limit the disclosure to the precise forms disclosed. Numerous modifications and adaptations thereof will be apparent to those skilled in the art without departing from the spirit and scope of the disclosure.

Reference herein to an example or implementation means that a particular feature, structure, operation, or other characteristic described in connection with the example may be included in at least one implementation of the disclosure. The disclosure is not restricted to the particular examples or implementations described as such. The appearance of the phrases "in one example," "in an example," "in one implementation," or "in an implementation," or variations of the same in various places in the specification does not necessarily refer to the same example or implementation. Any particular feature, structure, operation, or other characteristic described in this specification in relation to one example or implementation may be combined with other features, structures, operations, or other characteristics described in respect of any other example or implementation.

Use herein of the word "or" is intended to cover inclusive and exclusive OR conditions. In other words, A or B or C includes any or all of the following alternative combinations as appropriate for a particular usage: A alone; B alone; C alone; A and B only; A and C only; B and C only; and A and B and C.

## Claims

1. A sensor apparatus comprising:
a dual pixel array comprising a controller, a memory, and an array of pixels, each pixel comprising a plurality of photodiodes, each photodiode configured to generate a charge in response to incoming light, wherein the plurality of photodiodes comprises:
one or more color photodiodes each including a chromatic filter; a color-select switch; and having at least one associated monochrome photodiode with a monochrome filter and a monochrome-select switch; and
a plurality of charge storage devices, each charge storage device configured to convert the charge to a voltage,
wherein the color photodiodes and the monochrome photodiodes are arranged according to an arrangement;
one or more color analog-to-digital converters ("ADC"), each color ADC connected to at least one of the charge storage devices of the color photodiodes via the respective color-select switch, configured to selectively convert one or more stored voltages into a pixel value in response to a control signal; and
one or more monochrome ADCs, each monochrome ADC connected to at least one of the charge storage devices of the monochrome photodiodes via the respective monochrome-select switch, configured to selectively convert one or more stored voltages into a pixel value in response to a control signal.

2. The sensor apparatus of claim 1, wherein the one or more color photodiodes include at least one red photodiode comprising a red chromatic filter, at least one green photodiode comprising a green chromatic filter, and at least one blue photodiode comprising a blue chromatic filter.

3. The sensor apparatus of claim 1 or 2, wherein the monochrome filter comprises at least an infra-red filter, an ultraviolet filter, or a monochrome filter.

4. The sensor apparatus of any preceding claim, wherein each photodiode has an associated microlens.

5. The sensor apparatus of claim 2, wherein the arrangement comprises:
a first row including a repeating pattern of color and monochrome photodiodes; and
a second row including a repeating pattern of color and monochrome photodiodes,
wherein successive rows of the arrangement alternate between the first and second rows.

6. The sensor apparatus of claim 5, wherein:
the repeating pattern of the first row includes photodiodes with filters having the sequence: red, monochrome, green, monochrome; and
the repeating pattern of the second row includes photodiodes with filters having the sequence: green, monochrome, blue, monochrome.

7. The sensor apparatus of claim 2, wherein the arrangement comprises:
a third row including a repeating pattern of color and monochrome photodiodes; and
a fourth row including a repeating pattern of monochrome and color photodiodes,
wherein successive rows of the arrangement alternate between the third and fourth rows, in which case optionally wherein:
the repeating pattern of the third row includes photodiodes with filters having the sequence: red, monochrome, green, monochrome; and
the repeating pattern of the fourth row includes photodiodes with filters having the sequence: monochrome, green, monochrome, blue.

8. The sensor apparatus of claim 2, wherein the arrangement includes at least one color photodiode adjacent to at least one monochrome photodiode, in which case optionally wherein the adjacent photodiodes are associated with a first microlens.

9. The sensor apparatus of any preceding claim, and any one or more of:
a) wherein a second microlens is associated with four photodiodes arranged in a 2x2 configuration; or
b) wherein a third microlens is associated with eight photodiodes arranged in a 4x2 configuration.

10. The sensor apparatus of claim 2, wherein the color ADCs comprise at least one red ADC associated with the red photodiode, at least one green ADC associated with the green photodiode, and at least one blue ADC associated with the blue photodiode.

11. The sensor apparatus of claim 10, and any one or more of:
a) wherein the pixel values associated with the red, green, and blue ADCs are multiplied by 0.271, 0.589, and 0.0073, respectively, and combined with the pixel value from the monochrome ADCs of the associated monochrome photodiodes to produce an enhanced monochrome image; or
b) wherein a conversion factor for each color is determined according to environmental lighting conditions and the pixel value from a first monochrome ADCs is divided by a red conversion factor and combined with the pixel value from the associated red ADC, the pixel value from a second monochrome ADC is divided by a green conversion factor and combined with the pixel value from the associated green ADC, and the pixel value from a third monochrome ADC is divided by a blue conversion factor and combined with the pixel value from the associated blue ADC to produce an enhanced color image.

12. A system comprising:
a head-mounted display, wherein the head-mounted display comprises:
a dual pixel array comprising a controller, a memory, and an array of pixels, each pixel comprising a plurality of photodiodes, each photodiode configured to generate a charge in response to incoming light, wherein the plurality of photodiodes comprises:
one or more color photodiodes each including a chromatic filter; a color-select switch; and having at least one associated monochrome photodiode with a monochrome filter and a monochrome-select switch; and
a plurality of charge storage devices, each charge storage device configured to convert the charge to a voltage,
wherein the color photodiodes and the monochrome photodiodes are arranged according to an arrangement;
one or more color analog-to-digital converters ("ADC"), each color ADC connected to at least one of the charge storage devices of the color photodiodes via the respective color-select switch, configured to selectively convert one or more stored voltages into a pixel value in response to a control signal; and
one or more monochrome ADCs, each monochrome ADC connected to at least one of the charge storage devices of the monochrome photodiodes via the respective monochrome-select switch, configured to selectively convert one or more stored voltages into a pixel value in response to a control signal.

13. The system of claim 12, further comprising a color filter array ("CFA"), wherein the CFA comprises one or more chromatic filters of the color photodiodes and each chromatic filter of the CFA has an associated color ADC, wherein:
the pixel values of the color ADCs associated with the CFA are combined to produce a color image; and
a conversion factor for each color is determined according to environmental lighting conditions and the pixel value from a first monochrome ADCs is divided by a red conversion factor and combined with the pixel value from the associated red ADC, the pixel value from a second monochrome ADC is divided by a green conversion factor and combined with the pixel value from the associated green ADC, and the pixel value from a third monochrome ADC is divided by a blue conversion factor and combined with the pixel value from the associated blue ADC to produce an enhanced color image.

14. A method performed using a sensor apparatus comprising a controller, a memory, and a plurality of photodiodes, including one or more color photodiodes each including a chromatic filter; a color-select switch; and having at least one associated monochrome photodiode with a monochrome filter and a monochrome-select switch; and being connected to an analog-to-digital converter (ADC), the method comprising:
arranging the color photodiodes and the monochrome photodiodes according to an arrangement;
converting, by the photodiodes, incoming light to charge;
converting, by a charge storage device, the charge to a voltage;
generating, using the ADCs corresponding to the color photodiodes a pixel value for one or more color photodiodes via the respective color-select switch; and
generating, using the ADCs corresponding to the monochrome photodiodes a pixel value for one or more monochrome photodiodes via the respective monochrome-select switch.

15. The method of claim 14, and any one or more of:
a) wherein the arrangement comprises
a first row including a repeating pattern of color and monochrome photodiodes; and
a second row including a repeating pattern of color and monochrome photodiodes,
wherein:
successive rows of the arrangement alternate between the first and second rows;
the repeating pattern of the first row includes photodiodes with filters having the sequence: red, monochrome, green, monochrome; and
the repeating pattern of the second row includes photodiodes with filters having the sequence: green, monochrome, blue, monochrome; or
b) wherein the arrangement includes at least one color photodiode adjacent to at least one monochrome photodiode.
